(19) **Europäisches Patentamt**
**European Patent Office**
**Office européen des brevets**

(11) **EP 4 228 123 A1**

(12) **EUROPEAN PATENT APPLICATION**
published in accordance with Art. 153(4) EPC

(43) Date of publication:
**16.08.2023 Bulletin 2023/33**

(21) Application number: **21878029.4**

(22) Date of filing: **07.10.2021**

(51) International Patent Classification (IPC):
**H02J 50/60** (2016.01) **H02J 50/12** (2016.01)
**H01F 38/14** (2006.01)

(52) Cooperative Patent Classification (CPC):
**H01F 38/14; H02J 50/12; H02J 50/60**

(86) International application number:
**PCT/KR2021/013817**

(87) International publication number:
**WO 2022/075779 (14.04.2022 Gazette 2022/15)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.10.2020 KR 20200129084**

(71) Applicant: **LG Electronics Inc.**
**Yeongdeungpo-gu**
**Seoul 07336 (KR)**

(72) Inventors:
• **KIM, Jaeyeol**
**Seoul 06772 (KR)**
• **KIM, Hyoungseok**
**Seoul 06772 (KR)**
• **LEE, Seonghun**
**Seoul 06772 (KR)**
• **YOOK, Gyunghwan**
**Seoul 06772 (KR)**
• **KIM, Hongkwon**
**Seoul 06772 (KR)**

(74) Representative: **Plasseraud IP**
**66, rue de la Chaussée d'Antin**
**75440 Paris Cedex 09 (FR)**

(54) **WIRELESS POWER TRANSMITTER AND WIRELESS POWER TRANSMISSION METHOD BY WIRELESS POWER TRANSMITTER**

(57) In a wireless power transmission method according to an embodiment of the present specification, a power transmission step comprises: receiving, from a wireless power receiver, a reception power packet including information related to a reception power value; stopping transmission of wireless power for a slot time on the basis of the reception power value; and detecting a foreign material on the basis of a change in voltage or current within the slot time.

FIG. 27

EP 4 228 123 A1

**Description**

**TECHNICAL FIELD**

The present specification relates to a wireless power transmitter for transmitting wireless power to a wireless power receiver, a wireless power transmission method for detecting a foreign object between the wireless power receiver and the wireless power transmitter by the wireless power transmitter, and the like.

**BACKGROUND ART**

The wireless power transfer (or transmission) technology corresponds to a technology that may wirelessly transfer (or transmit) power between a power source and an electronic device. For example, by allowing the battery of a wireless device, such as a smartphone or a tablet PC, and so on, to be recharged by simply loading the wireless device on a wireless charging pad, the wireless power transfer technique may provide more outstanding mobility, convenience, and safety as compared to the conventional wired charging environment, which uses a wired charging connector. Apart from the wireless charging of wireless devices, the wireless power transfer technique is raising attention as a replacement for the conventional wired power transfer environment in diverse fields, such as electric vehicles, Bluetooth earphones, 3D glasses, diverse wearable devices, household (or home) electric appliances, furniture, underground facilities, buildings, medical equipment, robots, leisure, and so on.

The wireless power transfer (or transmission) method is also referred to as a contactless power transfer method, or a no point of contact power transfer method, or a wireless charging method. A wireless power transfer system may be configured of a wireless power transmitter supplying electric energy by using a wireless power transfer method, and a wireless power receiver receiving the electric energy being supplied by the wireless power transmitter and supplying the receiving electric energy to a receiver, such as a battery cell, and so on.

The wireless power transfer technique includes diverse methods, such as a method of transferring power by using magnetic coupling, a method of transferring power by using radio frequency (RF), a method of transferring power by using microwaves, and a method of transferring power by using ultrasound (or ultrasonic waves). The method that is based on magnetic coupling is categorized as a magnetic induction method and a magnetic resonance method. The magnetic induction method corresponds to a method transmitting power by using electric currents that are induced to the coil of the receiver by a magnetic field, which is generated from a coil battery cell of the transmitter, in accordance with an electromagnetic coupling between a transmitting coil and a receiving coil. The magnetic resonance method is similar to the magnetic induction method in that is uses a magnetic field. However, the magnetic resonance method is different from the magnetic induction method in that energy is transmitted due to a concentration of magnetic fields on both a transmitting end and a receiving end, which is caused by the generated resonance.

**DISCLOSURE**

**TECHNICAL PROBLEM**

A technical problem of the present specification is to provide a method for more accurately detecting a foreign substance while transmitting wireless power to a wireless power receiver.

Alternatively, the technical problem of the present specification is to provide a method of detecting foreign matter in a power calibration process.

The technical tasks of the present specification are not limited to the tasks mentioned above, and other tasks not mentioned will be clearly understood by those skilled in the art from the description below.

**TECHNICAL SOLUTION**

A wireless power transmission method according to an embodiment of the present specification for solving the above problems is a method for transmitting wireless power to a wireless power receiver, the method performed by a wireless power transmitter, and the method comprises a ping phase for transmitting a digital ping to the wireless power receiver and receiving a response for the digital ping from the wireless power receiver, a configuration phase for receiving a configuration packet from the wireless power receiver, a negotiation phase for receiving a foreign object detection status packet including information related to a reference quality factor value from the wireless power receiver, and detecting a foreign object based on the reference quality factor value and a power transfer phase for transmitting the wireless power to the wireless power receiver, wherein, in the power transfer phase, a received power packet including information related to a received power value is received from the wireless power receiver, based on the received power value, the transmission of the wireless power is stopped during a slot time, and the foreign object is detected based on a change in voltage or current within the slot time.

A wireless power transmission device according to an embodiment of the present specification for solving the above problems is a wireless power transmitter, which transmits wireless power to a wireless power receiver, and the wireless power transmitter comprises a power conversion circuit including a primary coil for transmitting the wireless power to the wireless power receiver and a communication/control circuit for communicating with the wireless power receiver and controlling the power conversion circuit, wherein the communication/control circuit performs a ping phase for transmitting a digital ping to the wireless power receiver and receiving a response for the digital ping from the wireless power receiver, a configuration phase for receiving a configuration packet from the wireless power receiver, a negotiation phase for receiving a foreign object detection status packet including information related to a reference quality factor value from the wireless power receiver, and detecting a foreign object based on the reference quality factor value and a power transfer phase for transmitting the wireless power to the wireless power receiver, wherein, in the power transfer phase, a received power packet including information related to a received power value is received from the wireless power receiver, based on the received power value, the transmission of the wireless power is stopped during a slot time, and the foreign object is detected based on a change in voltage or current of the primary coil within the slot time.

Other specific details of this specification are included in the detailed description and drawings.

## ADVANTAGEOUS EFFECTS

If a change in power loss occurs while transmitting wireless power to the wireless power receiver, the wireless power transmitter temporarily stops transmitting wireless power and uses the quality factor (Q factor) measured to check whether the change in actual power loss is caused by a foreign object, foreign object detection during power transfer can be performed more accurately.

Alternatively, when the change in power loss occurring during power transmission is not caused by a foreign object, power recalibration is performed so that the wireless charging protocol can be operated more efficiently.

Alternatively, since transmission of wireless power is stopped, a quality factor (Q factor) and a frequency change are measured together, and a foreign object is detected using both, it is possible to perform more accurate foreign object detection.

Alternatively, more accurate power calibration may be performed by detecting a foreign object during the power calibration protocol.

The effect according to the present document is not limited by the contents exemplified above, and more various effects are included in the present specification.

## BRIEF DESCRIPTION OF THE DRAWINGS

FIG. 1 is a block diagram of a wireless power system (10) according to an exemplary embodiment of the present disclosure.

FIG. 2 is a block diagram of a wireless power system (10) according to another exemplary embodiment of the present disclosure.

FIG. 3a shows an exemplary embodiment of diverse electronic devices adopting a wireless power transfer system.

FIG. 3b shows an example of a WPC NDEF in a wireless power transfer system.

FIG. 4 is a block diagram of a wireless power transfer system according to another exemplary embodiment of the present disclosure.

FIG. 5 is a state transition diagram for describing a wireless power transfer procedure.

FIG. 6 shows a power control method according to an exemplary embodiment of the present disclosure.

FIG. 7 is a block diagram of a wireless power transmitter according to another exemplary embodiment of the present disclosure.

FIG. 8 shows a wireless power receiver according to another exemplary embodiment of the present disclosure.

FIG. 9 is a flowchart schematically illustrating a protocol of a ping phase according to an embodiment.

FIG. 10 is a flowchart schematically illustrating a protocol of a configuration phase according to an embodiment.

FIG. 11 is a diagram illustrating a message field of a configuration packet (CFG) of a wireless power receiver according to an embodiment.

FIG. 12 is a flowchart schematically illustrating a protocol of a negotiation step or a renegotiation step according to an embodiment.

FIG. 13 is a diagram illustrating a message field of a capability packet (CAP) of a wireless power transmitter according to an embodiment.

FIG. 14 is a flowchart schematically illustrating a protocol of a power transmission step according to an embodiment.

FIG. 15 is a schematic circuit diagram of a wireless power transmitter supporting a foreign object detection method by Slotted Q FOD.

FIG. 16 is a graph schematically showing a voltage attenuation waveform of a primary coil during a slot time.

FIG. 17 is a flowchart illustrating a foreign object detection method according to an embodiment.

FIG. 18 is a diagram showing an example of data acquired in step S 1504.

FIG. 19 is a diagram for explaining a method of obtaining effective peak values according to an exemplary embodiment.

FIG. 20 is a diagram for explaining a regression analysis method according to an embodiment.

FIG. 21 is a flowchart for explaining a method of obtaining a reference Q factor according to an embodiment.

FIG. 22 is a flowchart for explaining a double-point power calibration method.

FIG. 23 is a graph showing an example of a power calibration curve by a double-point power calibration method.

FIG. 24 is a diagram showing a format of a message field of a received power packet according to an example.

FIG. 25 is a diagram illustrating a format of a message field of a received power packet according to another example.

FIG. 26 is a flowchart illustrating an improved power calibration method according to an embodiment.

FIG. 27 is a flowchart illustrating a method of determining a foreign object during power transfer according to an exemplary embodiment.

FIG. 28 is a chart showing experimental values of frequency change and Q factor reduction for coins of each country.

## MODE FOR INVENTION

In this specification, "A or B" may refer to "only A", "only B" or "both A and B". In other words, "A or B" in this specification may be interpreted as "A and/or B". For example, in this specification, "A, B, or C" may refer to "only A", "only B", "only C", or any combination of "A, B and C".

The slash (/) or comma used in this specification may refer to "and/or". For example, "A/B" may refer to "A and/or B". Accordingly, "A/B" may refer to "only A", "only B", or "both A and B". For example, "A, B, C" may refer to "A, B, or C".

In this specification, "at least one of A and B" may refer to "only A", "only B", or "both A and B". In addition, in this specification, the expression of "at least one of A or B" or "at least one of A and/or B" may be interpreted to be the same as "at least one of A and B".

Also, in this specification, "at least one of A, B and C" may refer to "only A", "only B", "only C", or "any combination of A, B and C". Also, "at least one of A, B or C" or "at least one of A, B and/or C" may refer to "at least one of A, B and C".

In addition, parentheses used in the present specification may refer to "for example". Specifically, when indicated as "control information (PDCCH)", "PDCCH" may be proposed as an example of "control information". In other words, "control information" in this specification is not limited to "PDCCH", and "PDDCH" may be proposed as an example of "control information". In addition, even when indicated as "control information (i.e., PDCCH)", "PDCCH" may be proposed as an example of "control information".

In the present specification, technical features that are individually described in one drawing may be individually or simultaneously implemented. The term "wireless power", which will hereinafter be used in this specification, will be used to refer to an arbitrary form of energy that is related to an electric field, a magnetic field, and an electromagnetic field, which is transferred (or transmitted) from a wireless power transmitter to a wireless power receiver without using any physical electromagnetic conductors. The wireless power may also be referred to as a wireless power signal, and this may refer to an oscillating magnetic flux that is enclosed by a primary coil and a secondary coil. For example, power conversion for wirelessly charging devices including mobile phones, cordless phones, iPods, MP3 players, headsets, and so on, within the system will be described in this specification. Generally, the basic principle of the wireless power transfer technique includes, for example, all of a method of transferring power by using magnetic coupling, a method of transferring power by using radio frequency (RF), a method of transferring power by using microwaves, and a method of transferring power by using ultrasound (or ultrasonic waves).

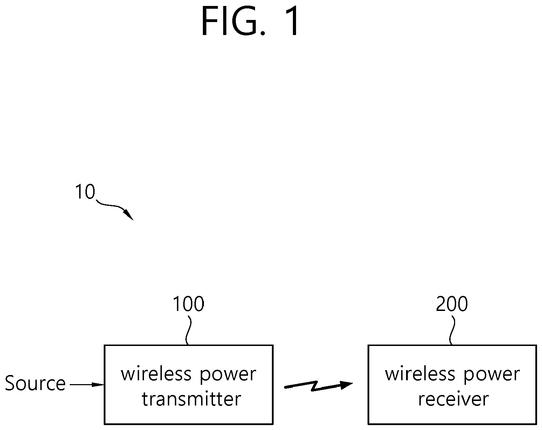

FIG. 1 is a block diagram of a wireless power system (10) according to an exemplary embodiment of the present disclosure.

Referring to FIG. 1, the wireless power system (10) include a wireless power transmitter (100) and a wireless power receiver (200).

The wireless power transmitter (100) is supplied with power from an external power source (S) and generates a magnetic field. The wireless power receiver (200) generates electric currents by using the generated magnetic field, thereby being capable of wirelessly receiving power.

Additionally, in the wireless power system (10), the wireless power transmitter (100) and the wireless power receiver (200) may transceive (transmit and/or receive) diverse information that is required for the wireless power transfer. Herein, communication between the wireless power transmitter (100) and the wireless power receiver (200) may be performed (or established) in accordance with any one of an in-band communication, which uses a magnetic field that is used for the wireless power transfer (or transmission), and an out-band communication, which uses a separate communication carrier. Out-band communication may also be referred to as out-of-band communication. Hereinafter, out-band communication will be largely described. Examples of out-band communication may include NFC, Bluetooth, Bluetooth low energy (BLE), and the like.

Herein, the wireless power transmitter (100) may be provided as a fixed type or a mobile (or portable) type. Examples of the fixed transmitter type may include an embedded type, which is embedded in in-door ceilings or wall surfaces or embedded in furniture, such as tables, an implanted type, which is installed in out-door parking lots, bus stops, subway stations, and so on, or being installed in means of transportation, such as vehicles or trains. The mobile (or portable) type wireless power transmitter (100) may be implemented as a part of another device, such as a mobile device having a portable size or weight or a cover of a laptop computer, and so on.

Additionally, the wireless power receiver (200) should be interpreted as a comprehensive concept including diverse home appliances and devices that are operated by being wirelessly supplied with power instead of diverse electronic devices being equipped with a battery and a power cable. Typical examples of the wireless power receiver (200) may include portable terminals, cellular phones, smartphones, personal digital assistants (PDAs), portable media players (PDPs), Wibro terminals, tablet PCs, phablet, laptop computers, digital cameras, navigation terminals, television, electronic vehicles (EVs), and so on.

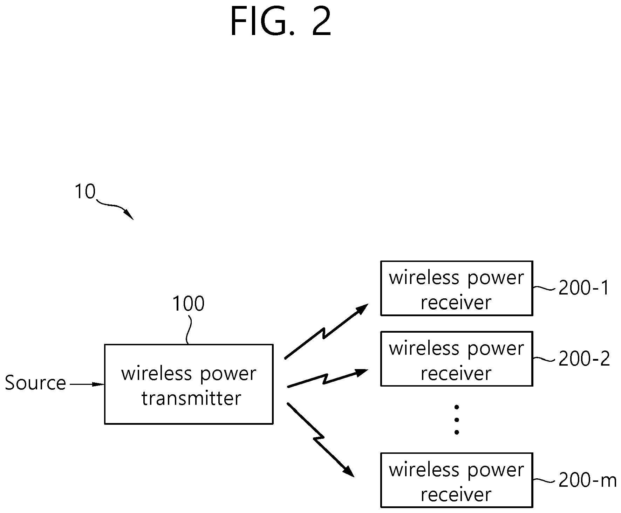

FIG. 2 is a block diagram of a wireless power system (10) according to another exemplary embodiment of the present disclosure.

Referring to FIG. 2, in the wireless power system (10), one wireless power receiver (200) or a plurality of wireless power receivers may exist. Although it is shown in FIG. 1 that the wireless power transmitter (100) and the wireless power receiver (200) send and receive power to and from one another in a one-to-one correspondence (or relationship), as shown in FIG. 2, it is also possible for one wireless power transmitter (100) to simultaneously transfer power to multiple wireless power receivers (200-1, 200-2, ..., 200-M). Most particularly, in case the wireless power transfer (or transmission) is performed by using a magnetic resonance method, one wireless power transmitter (100) may transfer power to multiple wireless power receivers (200-1, 200-2, ..., 200-M) by using a synchronized transport (or transfer) method or a time-division transport (or transfer) method.

Additionally, although it is shown in FIG. 1 that the wireless power transmitter (100) directly transfers (or transmits) power to the wireless power receiver (200), the wireless power system (10) may also be equipped with a separate wireless power transceiver, such as a relay or repeater, for increasing a wireless power transport distance between the wireless power transmitter (100) and the wireless power receiver (200). In this case, power is delivered to the wireless power transceiver from the wireless power transmitter (100), and, then, the wireless power transceiver may transfer the received power to the wireless power receiver (200).

Hereinafter, the terms wireless power receiver, power receiver, and receiver, which are mentioned in this specification, will refer to the wireless power receiver (200). Also, the terms wireless power transmitter, power transmitter, and transmitter, which are mentioned in this specification, will refer to the wireless power transmitter (100).

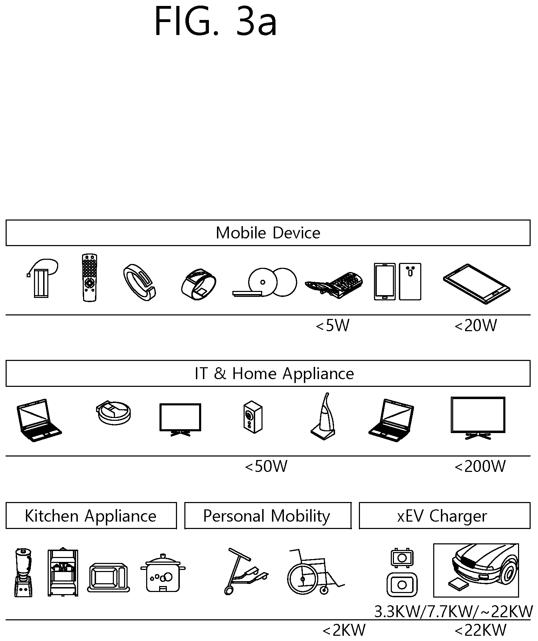

FIG. 3a shows an exemplary embodiment of diverse electronic devices adopting a wireless power transfer system.

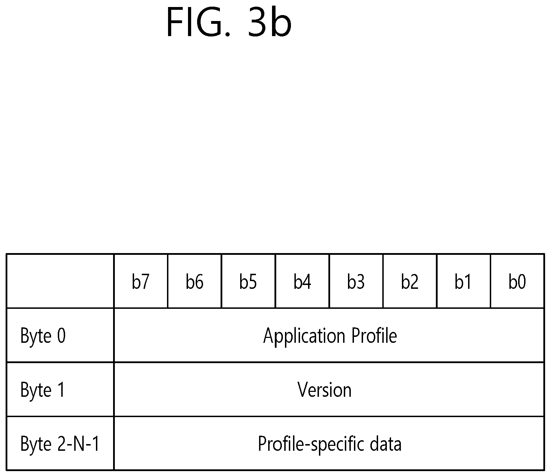

As shown in FIG. 3a, the electronic devices included in the wireless power transfer system are sorted in accordance with the amount of transmitted power and the amount of received power. Referring to FIG. 3, wearable devices, such as smart watches, smart glasses, head mounted displays (HMDs), smart rings, and so on, and mobile electronic devices (or portable electronic devices), such as earphones, remote controllers, smartphones, PDAs, tablet PCs, and so on, may adopt a low-power (approximately 5W or less or approximately 20W or less) wireless charging method.

Small-sized/Mid-sized electronic devices, such as laptop computers, robot vacuum cleaners, TV receivers, audio devices, vacuum cleaners, monitors, and so on, may adopt a mid-power (approximately 50W or less or approximately 200W or less) wireless charging method. Kitchen appliances, such as mixers, microwave ovens, electric rice cookers, and so on, and personal transportation devices (or other electric devices or means of transportation), such as powered wheelchairs, powered kick scooters, powered bicycles, electric cars, and so on may adopt a high-power (approximately 2kW or less or approximately 22kW or less) wireless charging method.

The electric devices or means of transportation, which are described above (or shown in FIG. 1) may each include a wireless power receiver, which will hereinafter be described in detail. Therefore, the above-described electric devices or means of transportation may be charged (or recharged) by wirelessly receiving power from a wireless power transmitter.

Hereinafter, although the present disclosure will be described based on a mobile device adopting the wireless power charging method, this is merely exemplary. And, therefore, it shall be understood that the wireless charging method according to the present disclosure may be applied to diverse electronic devices.

A standard for the wireless power transfer (or transmission) includes a wireless power consortium (WPC), an air fuel alliance (AFA), and a power matters alliance (PMA).

The WPC standard defines a baseline power profile (BPP) and an extended power profile (EPP). The BPP is related to a wireless power transmitter and a wireless power receiver supporting a power transfer of 5W, and the EPP is related to a wireless power transmitter and a wireless power receiver supporting the transfer of a power range greater than 5W and less than 30W.

Diverse wireless power transmitters and wireless power receivers each using a different power level may be covered by each standard and may be sorted by different power classes or categories.

For example, the WPC may categorize (or sort) the wireless power transmitters and the wireless power receivers as PC-1, PC0, PC1, and PC2, and the WPC may provide a standard document (or specification) for each power class (PC). The PC-1 standard relates to wireless power transmitters and receivers providing a guaranteed power of less than 5W. The application of PC-1 includes wearable devices, such as smart watches.

The PC0 standard relates to wireless power transmitters and receivers providing a guaranteed power of 5W. The PC0 standard includes an EPP having a guaranteed power ranges that extends to 30W. Although in-band (IB) communication corresponds to a mandatory communication protocol of PC0, out-of-band (OB) communication that is used as an optional backup channel may also be used for PC0. The wireless power receiver may be identified by setting up an OB flag, which indicates whether or not the OB is supported, within a configuration packet. A wireless power transmitter supporting the OB may enter an OB handover phase by transmitting a bit-pattern for an OB handover as a response to the configuration packet. The response to the configuration packet may correspond to an NAK, an ND, or an 8-bit pattern that is newly defined. The application of the PC0 includes smartphones.

The PC1 standard relates to wireless power transmitters and receivers providing a guaranteed power ranging from 30W to 150W. OB corresponds to a mandatory communication channel for PC1, and IB is used for initialization and link establishment to OB. The wireless power transmitter may enter an OB handover phase by transmitting a bit-pattern for an OB handover as a response to the configuration packet. The application of the PC1 includes laptop computers or power tools.

The PC2 standard relates to wireless power transmitters and receivers providing a guaranteed power ranging from 200W to 2kW, and its application includes kitchen appliances.

As described above, the PCs may be differentiated in accordance with the respective power levels. And, information on whether or not the compatibility between the same PCs is supported may be optional or mandatory. Herein, the compatibility between the same PCs indicates that power transfer/reception between the same PCs is possible. For example, in case a wireless power transmitter corresponding to PC x is capable of performing charging of a wireless power receiver having the same PC x, it may be understood that compatibility is maintained between the same PCs. Similarly, compatibility between different PCs may also be supported. Herein, the compatibility between different PCs indicates that power transfer/reception between different PCs is also possible. For example, in case a wireless power transmitter corresponding to PC x is capable of performing charging of a wireless power receiver having PC y, it may be understood that compatibility is maintained between the different PCs.

The support of compatibility between PCs corresponds to an extremely important issue in the aspect of user experience and establishment of infrastructure. Herein, however, diverse problems, which will be described below, exist in maintaining the compatibility between PCs.

In case of the compatibility between the same PCs, for example, in case of a wireless power receiver using a lap-top charging method, wherein stable charging is possible only when power is continuously transferred, even if its respective wireless power transmitter has the same PC, it may be difficult for the corresponding wireless power receiver to stably receive power from a wireless power transmitter of the power tool method, which transfers power non-continuously. Additionally, in case of the compatibility between different PCs, for example, in case a wireless power transmitter having a minimum guaranteed power of 200W transfers power to a wireless power receiver having a maximum guaranteed power of 5W, the corresponding wireless power receiver may be damaged due to an overvoltage. As a result, it may be inappropriate (or difficult) to use the PS as an index/reference standard representing/indicating the compatibility.

Wireless power transmitters and receivers may provide a very convenient user experience and interface (UX/UI). That is, a smart wireless charging service may be provided, and the smart wireless charging service may be implemented based on a UX/UI of a smartphone including a wireless power transmitter. For these applications, an interface between a processor of a smartphone and a wireless charging receiver allows for "drop and play" two-way communication between the wireless power transmitter and the wireless power receiver.

Hereinafter, 'profiles' will be newly defined based on indexes/reference standards representing/indicating the compatibility. More specifically, it may be understood that by maintaining compatibility between wireless power transmitters and receivers having the same 'profile', stable power transfer/reception may be performed, and that power transfer/reception between wireless power transmitters and receivers having different 'profiles' cannot be performed. The 'profiles' may be defined in accordance with whether or not compatibility is possible and/or the application regardless of (or independent from) the power class.

For example, the profile may be sorted into 3 different categories, such as i) Mobile, ii) Power tool and iii) Kitchen.

For another example, the profile may be sorted into 4 different categories, such as i) Mobile, ii) Power tool, iii) Kitchen, and iv) Wearable.

In case of the 'Mobile' profile, the PC may be defined as PC0 and/or PC1, the communication protocol/method may be defined as IB and OB communication, and the operation frequency may be defined as 87 to 205kHz, and smartphones, laptop computers, and so on, may exist as the exemplary application.

In case of the 'Power tool' profile, the PC may be defined as PC1, the communication protocol/method may be defined as IB communication, and the operation frequency may be defined as 87 to 145kHz, and power tools, and so on, may exist as the exemplary application.

In case of the 'Kitchen' profile, the PC may be defined as PC2, the communication protocol/method may be defined as NFC-based communication, and the operation frequency may be defined as less than 100kHz, and kitchen/home appliances, and so on, may exist as the exemplary application.

In the case of power tools and kitchen profiles, NFC communication may be used between the wireless power transmitter and the wireless power receiver. The wireless power transmitter and the wireless power receiver may confirm that they are NFC devices with each other by exchanging WPC NFC data exchange profile format (NDEF).

FIG. 3b shows an example of a WPC NDEF in a wireless power transfer system.

Referring to FIG. 3b, the WPC NDEF may include, for example, an application profile field (e.g., 1B), a version field (e.g., 1B), and profile specific data (e.g., 1B). The application profile field indicates whether the corresponding device is i) mobile and computing, ii) power tool, and iii) kitchen, and an upper nibble in the version field indicates a major version and a lower nibble indicates a minor version. In addition, profile-specific data defines content for the kitchen.

In case of the 'Wearable' profile, the PC may be defined as PC-1, the communication protocol/method may be defined as IB communication, and the operation frequency may be defined as 87 to 205kHz, and wearable devices that are worn by the users, and so on, may exist as the exemplary application.

It may be mandatory to maintain compatibility between the same profiles, and it may be optional to maintain compatibility between different profiles.

The above-described profiles (Mobile profile, Power tool profile, Kitchen profile, and Wearable profile) may be generalized and expressed as first to nth profile, and a new profile may be added/replaced in accordance with the WPC standard and the exemplary embodiment.

In case the profile is defined as described above, the wireless power transmitter may optionally perform power transfer only to the wireless power receiving corresponding to the same profile as the wireless power transmitter, thereby being capable of performing a more stable power transfer. Additionally, since the load (or burden) of the wireless power transmitter may be reduced and power transfer is not attempted to a wireless power receiver for which compatibility is not possible, the risk of damage in the wireless power receiver may be reduced.

PC1 of the 'Mobile' profile may be defined by being derived from an optional extension, such as OB, based on PC0. And, the 'Power tool' profile may be defined as a simply modified version of the PC1 'Mobile' profile. Additionally, up until now, although the profiles have been defined for the purpose of maintaining compatibility between the same profiles, in the future, the technology may be evolved to a level of maintaining compatibility between different profiles. The wireless power transmitter or the wireless power receiver may notify (or announce) its profile to its counterpart by using diverse methods.

In the AFA standard, the wireless power transmitter is referred to as a power transmitting unit (PTU), and the wireless power receiver is referred to as a power receiving unit (PRU). And, the PTU is categorized to multiple classes, as shown in Table 1, and the PRU is categorized to multiple classes, as shown in Table 2.

[Table 1]

| PTU | $P_{TX\_IN\_MAX}$ | Minimum category support requirement | Minimum value for a maximum number of supported devices |
|---|---|---|---|
| Class 1 | 2W | 1x Category 1 | 1x Category 1 |
| Class 2 | 10W | 1x Category 3 | 2x Category 2 |
| Class 3 | 16W | 1x Category 4 | 2x Category 3 |
| Class 4 | 33W | 1x Category 5 | 3x Category 3 |
| Class 5 | 50W | 1x Category 6 | 4x Category 3 |
| Class 6 | 70W | 1x Category 7 | 5x Category 3 |

[Table 2]

| PRU | $P_{RX\_OUT\_MAX'}$ | Exemplary application |
|---|---|---|
| Category 1 | TBD | Bluetooth headset |
| Category 2 | 3.5W | Feature phone |
| Category 3 | 6.5W | Smartphone |
| Category 4 | 13W | Tablet PC, Phablet |
| Category 5 | 25W | Small form factor laptop |
| Category 6 | 37.5W | General laptop |
| Category 7 | 50W | Home appliance |

As shown in Table 1, a maximum output power capability of Class n PTU may be equal to or greater than the $P_{TX\_IN\_MAX}$ of the corresponding class. The PRU cannot draw a power that is higher than the power level specified in the corresponding category.

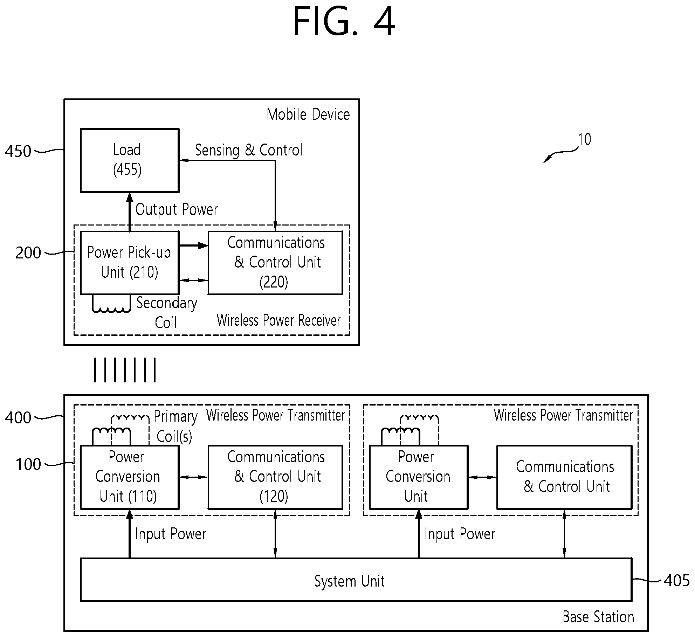

FIG. 4 is a block diagram of a wireless power transfer system according to another exemplary embodiment of the present disclosure.

Referring to FIG. 4, the wireless power transfer system (10) includes a mobile device (450), which wirelessly receives power, and a base station (400), which wirelessly transmits power.

As a device providing induction power or resonance power, the base station (400) may include at least one of a wireless power transmitter (100) and a system unit (405). The wireless power transmitter (100) may transmit induction power or resonance power and may control the transmission. The wireless power transmitter (100) may include a power conversion unit (110) converting electric energy to a power signal by generating a magnetic field through a primary coil (or primary coils), and a communications & control unit (120) controlling the communication and power transfer between the wireless power receiver (200) in order to transfer power at an appropriate (or suitable) level. The system unit (405) may perform input power provisioning, controlling of multiple wireless power transmitters, and other operation controls of the base station (400), such as user interface control.

The primary coil may generate an electromagnetic field by using an alternating current power (or voltage or current). The primary coil is supplied with an alternating current power (or voltage or current) of a specific frequency, which is being outputted from the power conversion unit (110). And, accordingly, the primary coil may generate a magnetic field of the specific frequency. The magnetic field may be generated in a non-radial shape or a radial shape. And, the wireless power receiver (200) receives the generated magnetic field and then generates an electric current. In other words, the primary coil wirelessly transmits power.

In the magnetic induction method, a primary coil and a secondary coil may have randomly appropriate shapes. For example, the primary coil and the secondary coil may correspond to copper wire being wound around a high-permeability formation, such as ferrite or a non-crystalline metal. The primary coil may also be referred to as a transmitting coil, a primary core, a primary winding, a primary loop antenna, and so on. Meanwhile, the secondary coil may also be referred to as a receiving coil, a secondary core, a secondary winding, a secondary loop antenna, a pickup antenna, and so on.

In case of using the magnetic resonance method, the primary coil and the secondary coil may each be provided in the form of a primary resonance antenna and a secondary resonance antenna. The resonance antenna may have a resonance structure including a coil and a capacitor. At this point, the resonance frequency of the resonance antenna may be determined by the inductance of the coil and a capacitance of the capacitor. Herein, the coil may be formed to have a loop shape. And, a core may be placed inside the loop. The core may include a physical core, such as a ferrite core, or an air core.

The energy transmission (or transfer) between the primary resonance antenna and the second resonance antenna may be performed by a resonance phenomenon occurring in the magnetic field. When a near field corresponding to a resonance frequency occurs in a resonance antenna, and in case another resonance antenna exists near the corresponding resonance antenna, the resonance phenomenon refers to a highly efficient energy transfer occurring between the two resonance antennas that are coupled with one another. When a magnetic field corresponding to the resonance frequency is generated between the primary resonance antenna and the secondary resonance antenna, the primary resonance antenna and the secondary resonance antenna resonate with one another. And, accordingly, in a general case, the magnetic field is focused toward the second resonance antenna at a higher efficiency as compared to a case where the magnetic field that is generated from the primary antenna is radiated to a free space. And, therefore, energy may be transferred to the second resonance antenna from the first resonance antenna at a high efficiency. The magnetic induction method may be implemented similarly to the magnetic resonance method. However, in this case, the frequency of the magnetic field is not required to be a resonance frequency. Nevertheless, in the magnetic induction method, the loops configuring the primary coil and the secondary coil are required to match one another, and the distance between the loops should be very close-ranged.

Although it is not shown in the drawing, the wireless power transmitter (100) may further include a communication antenna. The communication antenna may transmit and/or receive a communication signal by using a communication carrier apart from the magnetic field communication. For example, the communication antenna may transmit and/or receive communication signals corresponding to Wi-Fi, Bluetooth, Bluetooth LE, ZigBee, NFC, and so on.

The communications & control unit (120) may transmit and/or receive information to and from the wireless power receiver (200). The communications & control unit (120) may include at least one of an IB communication module and an OB communication module.

The IB communication module may transmit and/or receive information by using a magnetic wave, which uses a specific frequency as its center frequency. For example, the communications & control unit (120) may perform in-band (IB) communication by transmitting communication information on the operating frequency of wireless power transfer through the primary coil or by receiving communication information on the operating frequency through the primary coil. At this point, the communications & control unit (120) may load information in the magnetic wave or may interpret the information that is carried by the magnetic wave by using a modulation scheme, such as binary phase shift keying (BPSK), Frequency Shift Keying(FSK) or amplitude shift keying (ASK), and so on, or a coding scheme, such as Manchester coding or non-return-to-zero level (NZR-L) coding, and so on. By using the above-described IB communication, the communications & control unit (120) may transmit and/or receive information to distances of up to several meters at a data transmission rate of several kbps.

The OB communication module may also perform out-of-band communication through a communication antenna. For example, the communications & control unit (120) may be provided to a near field communication module. Examples of the near field communication module may include communication modules, such as Wi-Fi, Bluetooth, Bluetooth LE, ZigBee, NFC, and so on.

The communications & control unit (120) may control the overall operations of the wireless power transmitter (100). The communications & control unit (120) may perform calculation and processing of diverse information and may also control each configuration element of the wireless power transmitter (100).

The communications & control unit (120) may be implemented in a computer or a similar device as hardware, software, or a combination of the same. When implemented in the form of hardware, the communications & control unit (120) may be provided as an electronic circuit performing control functions by processing electrical signals. And, when implemented in the form of software, the communications & control unit (120) may be provided as a program that operates the communications & control unit (120).

By controlling the operating point, the communications & control unit (120) may control the transmitted power. The operating point that is being controlled may correspond to a combination of a frequency (or phase), a duty cycle, a duty ratio, and a voltage amplitude. The communications & control unit (120) may control the transmitted power by adjusting any one of the frequency (or phase), the duty cycle, the duty ratio, and the voltage amplitude. Additionally, the wireless power transmitter (100) may supply a consistent level of power, and the wireless power receiver (200) may control the level of received power by controlling the resonance frequency.

The mobile device (450) includes a wireless power receiver (200) receiving wireless power through a secondary coil, and a load (455) receiving and storing the power that is received by the wireless power receiver (200) and supplying the received power to the device.

The wireless power receiver (200) may include a power pick-up unit (210) and a communications & control unit (220). The power pick-up unit (210) may receive wireless power through the secondary coil and may convert the received wireless power to electric energy. The power pick-up unit (210) rectifies the alternating current (AC) signal, which is received through the secondary coil, and converts the rectified signal to a direct current (DC) signal. The communications & control unit (220) may control the transmission and reception of the wireless power (transfer and reception of power).

The secondary coil may receive wireless power that is being transmitted from the wireless power transmitter (100). The secondary coil may receive power by using the magnetic field that is generated in the primary coil. Herein, in case the specific frequency corresponds a resonance frequency, magnetic resonance may occur between the primary coil and the secondary coil, thereby allowing power to be transferred with greater efficiency.

Although it is not shown in FIG. 4, the communications & control unit (220) may further include a communication antenna. The communication antenna may transmit and/or receive a communication signal by using a communication carrier apart from the magnetic field communication. For example, the communication antenna may transmit and/or receive communication signals corresponding to Wi-Fi, Bluetooth, Bluetooth LE, ZigBee, NFC, and so on.

The communications & control unit (220) may transmit and/or receive information to and from the wireless power transmitter (100). The communications & control unit (220) may include at least one of an IB communication module and an OB communication module.

The IB communication module may transmit and/or receive information by using a magnetic wave, which uses a specific frequency as its center frequency. For example, the communications & control unit (220) may perform IB communication by loading information in the magnetic wave and by transmitting the information through the secondary coil or by receiving a magnetic wave carrying information through the secondary coil. At this point, the communications & control unit (120) may load information in the magnetic wave or may interpret the information that is carried by the magnetic wave by using a modulation scheme, such as binary phase shift keying (BPSK), Frequency Shift Keying(FSK) or amplitude shift keying (ASK), and so on, or a coding scheme, such as Manchester coding or non-return-to-zero level (NZR-L) coding, and so on. By using the above-described IB communication, the communications & control unit (220) may transmit and/or receive information to distances of up to several meters at a data transmission rate of several kbps.

The OB communication module may also perform out-of-band communication through a communication antenna. For example, the communications & control unit (220) may be provided to a near field communication module.

Examples of the near field communication module may include communication modules, such as Wi-Fi, Bluetooth, Bluetooth LE, ZigBee, NFC, and so on.

The communications & control unit (220) may control the overall operations of the wireless power receiver (200). The communications & control unit (220) may perform calculation and processing of diverse information and may also control each configuration element of the wireless power receiver (200).

The communications & control unit (220) may be implemented in a computer or a similar device as hardware, software, or a combination of the same. When implemented in the form of hardware, the communications & control unit (220) may be provided as an electronic circuit performing control functions by processing electrical signals. And, when implemented in the form of software, the communications & control unit (220) may be provided as a program that operates the communications & control unit (220).

Hereinafter, the coil or coil unit includes a coil and at least one device being approximate to the coil, and the coil or coil unit may also be referred to as a coil assembly, a coil cell, or a cell.

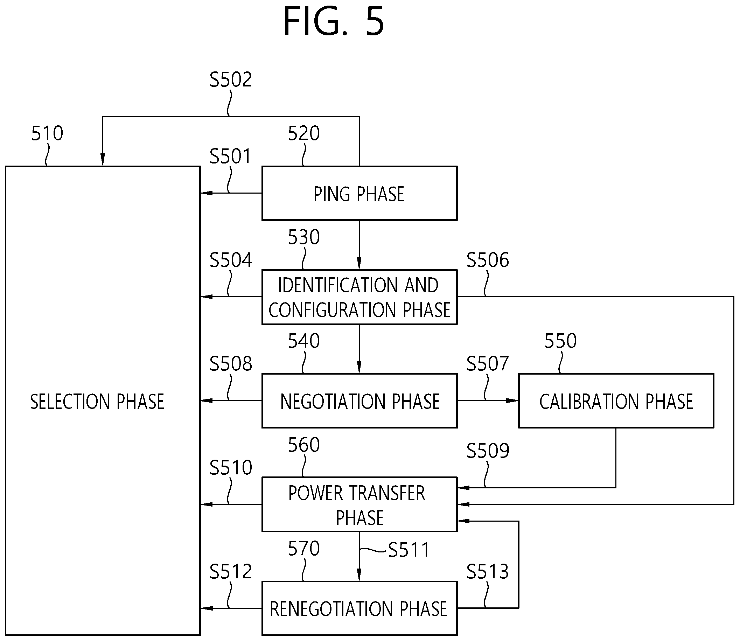

FIG. 5 is a state transition diagram for describing a wireless power transfer procedure.

Referring to FIG. 5, the power transfer (or transfer) from the wireless power transmitter to the wireless power receiver according to an exemplary embodiment of the present disclosure may be broadly divided into a selection phase (510), a ping phase (520), an identification and configuration phase (530), a negotiation phase (540), a calibration phase (550), a power transfer phase (560), and a renegotiation phase (570).

If a specific error or a specific event is detected when the power transfer is initiated or while maintaining the power transfer, the selection phase (510) may include a shifting phase (or step) - reference numerals S502, S504, S508, S510, and S512. Herein, the specific error or specific event will be specified in the following description. Additionally, during the selection phase (510), the wireless power transmitter may monitor whether or not an object exists on an interface surface. If the wireless power transmitter detects that an object is placed on the interface surface, the process step may be shifted to the ping phase (520). During the selection phase (510), the wireless power transmitter may transmit an analog ping having a power signal(or a pulse) corresponding to an extremely short duration, and may detect whether or not an object exists within an active area of the interface surface based on a current change in the transmitting coil or the primary coil.

In case an object is sensed (or detected) in the selection phase (510), the wireless power transmitter may measure a quality factor of a wireless power resonance circuit (e.g., power transfer coil and/or resonance capacitor). According to the exemplary embodiment of the present disclosure, during the selection phase (510), the wireless power transmitter may measure the quality factor in order to determine whether or not a foreign object exists in the charging area along with the wireless power receiver. In the coil that is provided in the wireless power transmitter, inductance and/or components of the series resistance may be reduced due to a change in the environment, and, due to such decrease, a value of the quality factor may also be decreased. In order to determine the presence or absence of a foreign object by using the measured quality factor value, the wireless power transmitter may receive from the wireless power receiver a reference quality factor value, which is measured in advance in a state where no foreign object is placed within the charging area. The wireless power transmitter may determine the presence or absence of a foreign object by comparing the measured quality factor value with the reference quality factor value, which is received during the negotiation phase (540). However, in case of a wireless power receiver having a low reference quality factor value - e.g., depending upon its type, purpose, characteristics, and so on, the wireless power receiver may have a low reference quality factor value - in case a foreign object exists, since the difference between the reference quality factor value and the measured quality factor value is small (or insignificant), a problem may occur in that the presence of the foreign object cannot be easily determined. Accordingly, in this case, other determination factors should be further considered, or the present or absence of a foreign object should be determined by using another method.

According to another exemplary embodiment of the present disclosure, in case an object is sensed (or detected) in the selection phase (510), in order to determine whether or not a foreign object exists in the charging area along with the wireless power receiver, the wireless power transmitter may measure the quality factor value within a specific frequency area (e.g., operation frequency area). In the coil that is provided in the wireless power transmitter, inductance and/or components of the series resistance may be reduced due to a change in the environment, and, due to such decrease, the resonance frequency of the coil of the wireless power transmitter may be changed (or shifted). More specifically, a quality factor peak frequency that corresponds to a frequency in which a maximum quality factor value is measured within the operation frequency band may be moved (or shifted).

In the ping phase (520), if the wireless power transmitter detects the presence of an object, the transmitter activates (or Wakes up) a receiver and transmits a digital ping for identifying whether or not the detected object corresponds to the wireless power receiver. During the ping phase (520), if the wireless power transmitter fails to receive a response signal for the digital ping - e.g., a signal intensity packet - from the receiver, the process may be shifted back to the selection phase (510). Additionally, in the ping phase (520), if the wireless power transmitter receives a signal indicating the completion of the power transfer - e.g., charging complete packet - from the receiver, the process may be shifted back to the selection phase (510).

If the ping phase (520) is completed, the wireless power transmitter may shift to the identification and configuration phase (530) for identifying the receiver and for collecting configuration and status information.

In the identification and configuration phase (530), if the wireless power transmitter receives an unwanted packet (i.e., unexpected packet), or if the wireless power transmitter fails to receive a packet during a predetermined period of time (i.e., out of time), or if a packet transmission error occurs (i.e., transmission error), or if a power transfer contract is not configured (i.e., no power transfer contract), the wireless power transmitter may shift to the selection phase (510).

The wireless power transmitter may confirm (or verify) whether or not its entry to the negotiation phase (540) is needed based on a Negotiation field value of the configuration packet, which is received during the identification and configuration phase (530). Based on the verified result, in case a negotiation is needed, the wireless power transmitter enters the negotiation phase (540) and may then perform a predetermined FOD detection procedure. Conversely, in case a negotiation is not needed, the wireless power transmitter may immediately enter the power transfer phase (560).

In the negotiation phase (540), the wireless power transmitter may receive a Foreign Object Detection (FOD) status packet that includes a reference quality factor value. Or, the wireless power transmitter may receive an FOD status packet that includes a reference peak frequency value. Alternatively, the wireless power transmitter may receive a status packet that includes a reference quality factor value and a reference peak frequency value. At this point, the wireless power transmitter may determine a quality coefficient threshold value for FO detection based on the reference quality factor value. The wireless power transmitter may determine a peak frequency threshold value for FO detection based on the reference peak frequency value.

The wireless power transmitter may detect the presence or absence of an FO in the charging area by using the determined quality coefficient threshold value for FO detection and the currently measured quality factor value (i.e., the quality factor value that was measured before the ping phase), and, then, the wireless power transmitter may control the transmitted power in accordance with the FO detection result. For example, in case the FO is detected, the power transfer may be stopped. However, the present disclosure will not be limited only to this.

The wireless power transmitter may detect the presence or absence of an FO in the charging area by using the determined peak frequency threshold value for FO detection and the currently measured peak frequency value (i.e., the peak frequency value that was measured before the ping phase), and, then, the wireless power transmitter may control the transmitted power in accordance with the FO detection result. For example, in case the FO is detected, the power transfer may be stopped. However, the present disclosure will not be limited only to this.

In case the FO is detected, the wireless power transmitter may return to the selection phase (510). Conversely, in case the FO is not detected, the wireless power transmitter may proceed to the calibration phase (550) and may, then, enter the power transfer phase (560). More specifically, in case the FO is not detected, the wireless power transmitter may determine the intensity of the received power that is received by the receiving end during the calibration phase (550) and may measure power loss in the receiving end and the transmitting end in order to determine the intensity of the power that is transmitted from the transmitting end. In other words, during the calibration phase (550), the wireless power transmitter may estimate the power loss based on a difference between the transmitted power of the transmitting end and the received power of the receiving end. The wireless power transmitter according to the exemplary embodiment of the present disclosure may calibrate the threshold value for the FOD detection by applying the estimated power loss.

In the power transfer phase (560), in case the wireless power transmitter receives an unwanted packet (i.e., unexpected packet), or in case the wireless power transmitter fails to receive a packet during a predetermined period of time (i.e., time-out), or in case a violation of a predetermined power transfer contract occurs (i.e., power transfer contract violation), or in case charging is completed, the wireless power transmitter may shift to the selection phase (510).

Additionally, in the power transfer phase (560), in case the wireless power transmitter is required to reconfigure the power transfer contract in accordance with a status change in the wireless power transmitter, the wireless power transmitter may shift to the renegotiation phase (570). At this point, if the renegotiation is successfully completed, the wireless power transmitter may return to the power transfer phase (560).

In this embodiment, the calibration step 550 and the power transfer phase 560 are divided into separate steps, but the calibration step 550 may be integrated into the power transfer phase 560. In this case, operations in the calibration step 550 may be performed in the power transfer phase 560.

The above-described power transfer contract may be configured based on the status and characteristic information of the wireless power transmitter and receiver. For example, the wireless power transmitter status information may include information on a maximum amount of transmittable power, information on a maximum number of receivers that may be accommodated, and so on. And, the receiver status information may include information on the required power, and so on.

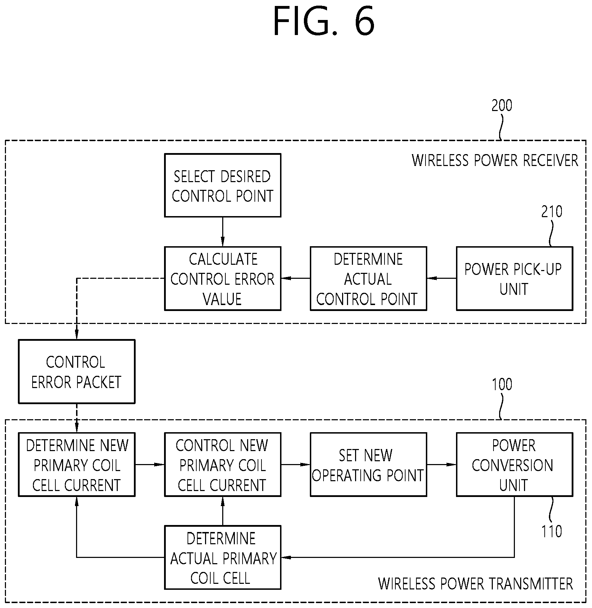

FIG. 6 shows a power control method according to an exemplary embodiment of the present disclosure.

As shown in FIG. 6, in the power transfer phase (560), by alternating the power transfer and/or reception and communication, the wireless power transmitter (100) and the wireless power receiver (200) may control the amount (or size) of the power that is being transferred. The wireless power transmitter and the wireless power receiver operate at a specific control point. The control point indicates a combination of the voltage and the electric current that are provided from the output of the wireless power receiver, when the power transfer is performed.

More specifically, the wireless power receiver selects a desired control point, a desired output current/voltage, a temperature at a specific location of the mobile device, and so on, and additionally determines an actual control point at which the receiver is currently operating. The wireless power receiver calculates a control error value by using the desired control point and the actual control point, and, then, the wireless power receiver may transmit the calculated control error value to the wireless power transmitter as a control error packet.

Also, the wireless power transmitter may configure/control a new operating point - amplitude, frequency, and duty cycle - by using the received control error packet, so as to control the power transfer. Therefore, the control error packet may be transmitted/received at a constant time interval during the power transfer phase, and, according to the exemplary embodiment, in case the wireless power receiver attempts to reduce the electric current of the wireless power transmitter, the wireless power receiver may transmit the control error packet by setting the control error value to a negative number. And, in case the wireless power receiver intends to increase the electric current of the wireless power transmitter, the wireless power receiver transmit the control error packet by setting the control error value to a positive number. During the induction mode, by transmitting the control error packet to the wireless power transmitter as described above, the wireless power receiver may control the power transfer.

In the resonance mode, which will hereinafter be described in detail, the device may be operated by using a method that is different from the induction mode. In the resonance mode, one wireless power transmitter should be capable of serving a plurality of wireless power receivers at the same time. However, in case of controlling the power transfer just as in the induction mode, since the power that is being transferred is controlled by a communication that is established with one wireless power receiver, it may be difficult to control the power transfer of additional wireless power receivers. Therefore, in the resonance mode according to the present disclosure, a method of controlling the amount of power that is being received by having the wireless power transmitter commonly transfer (or transmit) the basic power and by having the wireless power receiver control its own resonance frequency. Nevertheless, even during the operation of the resonance mode, the method described above in FIG. 6 will not be completely excluded. And, additional control of the transmitted power may be performed by using the method of FIG. 6.

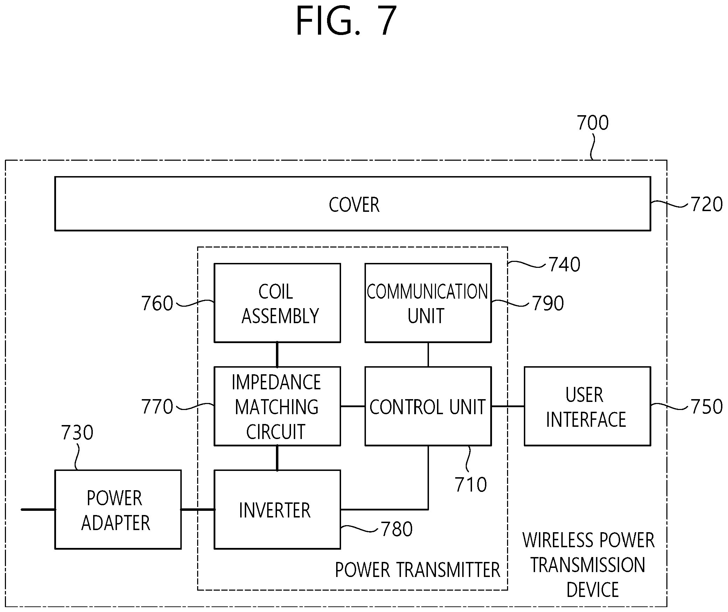

FIG. 7 is a block diagram of a wireless power transmitter according to another exemplary embodiment of the present disclosure. This may belong to a wireless power transfer system that is being operated in the magnetic resonance mode or the shared mode. The shared mode may refer to a mode performing a several-for-one (or one-to-many) communication and charging between the wireless power transmitter and the wireless power receiver. The shared mode may be implemented as a magnetic induction method or a resonance method.

Referring to FIG. 7, the wireless power transmitter (700) may include at least one of a cover (720) covering a coil assembly, a power adapter (730) supplying power to the power transmitter (740), a power transmitter (740) transmitting wireless power, and a user interface (750) providing information related to power transfer processing and other related information. Most particularly, the user interface (750) may be optionally included or may be included as another user interface (750) of the wireless power transmitter (700).

The power transmitter (740) may include at least one of a coil assembly (760), an impedance matching circuit (770), an inverter (780), a communication unit (790), and a control unit (710).

The coil assembly (760) includes at least one primary coil generating a magnetic field. And, the coil assembly (760) may also be referred to as a coil cell.

The impedance matching circuit (770) may provide impedance matching between the inverter and the primary coil(s). The impedance matching circuit (770) may generate resonance from a suitable frequency that boosts the electric current of the primary coil(s). In a multi-coil power transmitter (740), the impedance matching circuit may additionally include a multiplex that routes signals from the inverter to a subset of the primary coils. The impedance matching circuit may also be referred to as a tank circuit.

The impedance matching circuit (770) may include a capacitor, an inductor, and a switching device that switches the connection between the capacitor and the inductor. The impedance matching may be performed by detecting a reflective wave of the wireless power that is being transferred (or transmitted) through the coil assembly (760) and by switching the switching device based on the detected reflective wave, thereby adjusting the connection status of the capacitor or the inductor or adjusting the capacitance of the capacitor or adjusting the inductance of the inductor. In some cases, the impedance matching may be carried out even though the impedance matching circuit (770) is omitted. This specification also includes an exemplary embodiment of the wireless power transmitter (700), wherein the impedance matching circuit (770) is omitted.

The inverter (780) may convert a DC input to an AC signal. The inverter (780) may be operated as a half-bridge inverter or a full-bridge inverter in order to generate a pulse wave and a duty cycle of an adjustable frequency. Additionally, the inverter may include a plurality of stages in order to adjust input voltage levels.

The communication unit (790) may perform communication with the power receiver. The power receiver performs load modulation in order to communicate requests and information corresponding to the power transmitter. Therefore, the power transmitter (740) may use the communication unit (790) so as to monitor the amplitude and/or phase of the electric current and/or voltage of the primary coil in order to demodulate the data being transmitted from the power receiver.

Additionally, the power transmitter (740) may control the output power to that the data may be transferred through the communication unit (790) by using a Frequency Shift Keying (FSK) method, and so on.

The control unit (710) may control communication and power transfer (or delivery) of the power transmitter (740). The control unit (710) may control the power transfer by adjusting the above-described operating point. The operating point may be determined by, for example, at least any one of the operation frequency, the duty cycle, and the input voltage.

The communication unit (790) and the control unit (710) may each be provided as a separate unit/device/chipset or may be collectively provided as one unit/device/chipset.

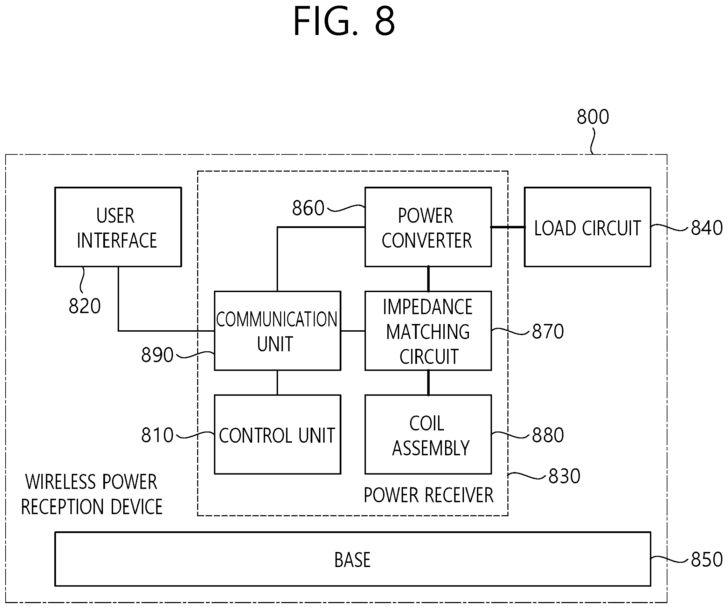

FIG. 8 shows a wireless power receiver according to another exemplary embodiment of the present disclosure. This may belong to a wireless power transfer system that is being operated in the magnetic resonance mode or the shared mode.

Referring to FIG. 8, the wireless power receiver (800) may include at least one of a user interface (820) providing information related to power transfer processing and other related information, a power receiver (830) receiving wireless power, a load circuit (840), and a base (850) supporting and covering the coil assembly. Most particularly, the user interface (820) may be optionally included or may be included as another user interface (820) of the wireless power receiver (800).

The power receiver (830) may include at least one of a power converter (860), an impedance matching circuit (870), a coil assembly (880), a communication unit (890), and a control unit (810).

The power converter (860) may convert the AC power that is received from the secondary coil to a voltage and electric current that are suitable for the load circuit. According to an exemplary embodiment, the power converter (860) may include a rectifier. The rectifier may rectify the received wireless power and may convert the power from an alternating current (AC) to a direct current (DC). The rectifier may convert the alternating current to the direct current by using a diode or a transistor, and, then, the rectifier may smooth the converted current by using the capacitor and resistance. Herein, a full-wave rectifier, a half-wave rectifier, a voltage multiplier, and so on, that are implemented as a bridge circuit may be used as the rectifier. Additionally, the power converter may adapt a reflected impedance of the power receiver.

The impedance matching circuit (870) may provide impedance matching between a combination of the power converter (860) and the load circuit (840) and the secondary coil. According to an exemplary embodiment, the impedance matching circuit may generate a resonance of approximately 100kHz, which may reinforce the power transfer. The impedance matching circuit (870) may include a capacitor, an inductor, and a switching device that switches the combination of the capacitor and the inductor. The impedance matching may be performed by controlling the switching device of the circuit that configured the impedance matching circuit (870) based on the voltage value, electric current value, power value, frequency value, and so on, of the wireless power that is being received. In some cases, the impedance matching may be carried out even though the impedance matching circuit (870) is omitted. This specification also includes an exemplary embodiment of the wireless power receiver (200), wherein the impedance matching circuit (870) is omitted.

The coil assembly (880) includes at least one secondary coil, and, optionally, the coil assembly (880) may further include an element shielding the metallic part of the receiver from the magnetic field.

The communication unit (890) may perform load modulation in order to communicate requests and other information to the power transmitter.

For this, the power receiver (830) may perform switching of the resistance or capacitor so as to change the reflected impedance.

The control unit (810) may control the received power. For this, the control unit (810) may determine/calculate a difference between an actual operating point and a target operating point of the power receiver (830). Thereafter, by performing a request for adjusting the reflected impedance of the power transmitter and/or for adjusting an operating point of the power transmitter, the difference between the actual operating point and the target operating point may be adjusted/reduced. In case of minimizing this difference, an optimal power reception may be performed.

The communication unit (890) and the control unit (810) may each be provided as a separate device/chipset or may be collectively provided as one device/chipset.

As described in FIG. 5 etc., the wireless power transmitter and the wireless power receiver go through a Ping Phase and a Configuration Phase to enter the Negotiation Phase, or may go through a ping phase, a configuration phase, and a negotiation phase to enter a power transfer phase and then to a re-negotiation phase.

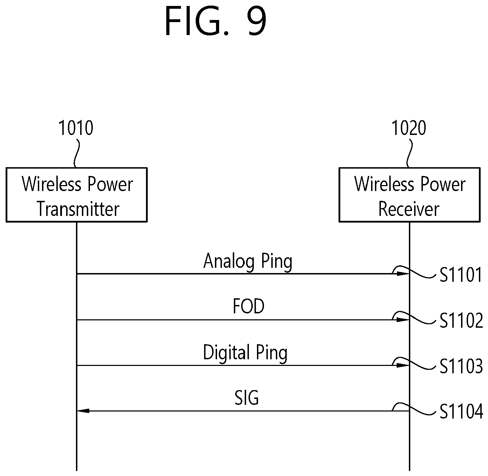

FIG. 9 is a flowchart schematically illustrating a protocol of a ping phase according to an embodiment.

Referring to FIG. 9, in the ping phase, the wireless power transmitter 1010 checks whether an object exists in an operating volume by transmitting an analog ping (S1101). The wireless power transmitter 1010 may detect whether an object exists in the working space based on a change in current of a transmission coil or a primary coil.

If it is determined that an object exists in the operating volume by analog ping, the wireless power transmitter 1010 may perform foreign object detection (FOD) before power transmission to check whether a foreign object exists in the operating volume (S1102). The wireless power transmitter 1010 may perform an operation for protecting the NFC card and/or the RFID tag.

Thereafter, the wireless power transmitter 1010 identifies the wireless power receiver 1020 by transmitting a digital ping (S1103). The wireless power receiver 1020 recognizes the wireless power transmitter 1010 by receiving the digital ping.

The wireless power receiver 1020 that has received the digital ping transmits a signal strength data packet (SIG) to the wireless power transmitter 1010 (S 1104).

The wireless power transmitter 1010 receiving the SIG from the wireless power receiver 1020 may identify that the wireless power receiver 1020 is located in the operating volume.

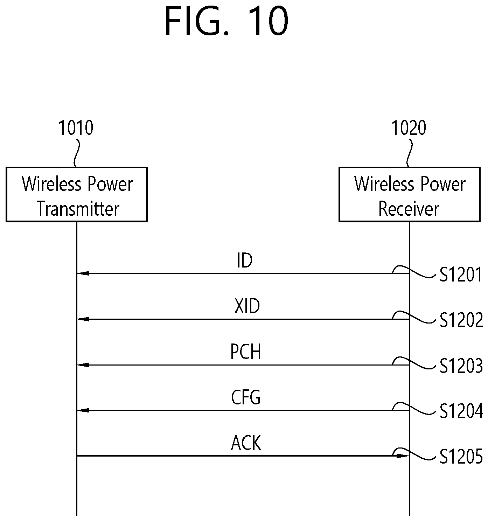

FIG. 10 is a flowchart schematically illustrating a protocol of a configuration phase according to an embodiment.

In the configuration phase (or identification and configuration phase), the wireless power receiver 1020 transmits its identification information to the wireless power transmitter 1010, the wireless power receiver 1020 and the wireless power transmitter 1010 may establish a baseline Power Transfer Contract.

Referring to FIG. 10, in the configuration phase, the wireless power receiver 1020 may transmit an identification data packet (ID) to the wireless power transmitter 1010 to identify itself (S1201). In addition, the wireless power receiver 1020 may transmit an XID (Extended Identification data packet) to the wireless power transmitter 1010 (S1202). In addition, the wireless power receiver 1020 may transmit a power control hold-off data packet (PCH) to the wireless power transmitter 1010 for a power transfer contract (S1203). In addition, the wireless power receiver 1020 may transmit a configuration data packet (CFG) to the wireless power transmitter (S1204).

In accordance with the Extended Protocol for EPP, the wireless power transmitter 1010 may transmit an ACK in response to the CFG (S1205).

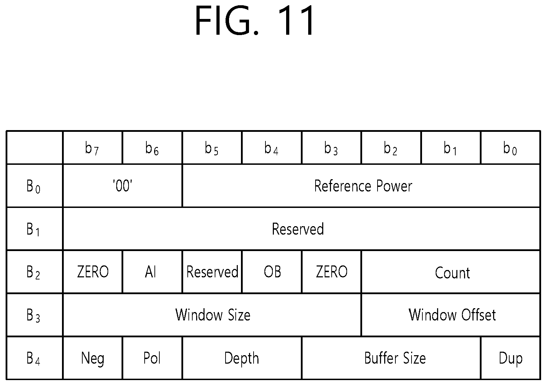

FIG. 11 is a diagram illustrating a message field of a configuration packet (CFG) of a wireless power receiver according to an embodiment.

A configuration packet (CFG) according to an embodiment may have a header value of 0x51 and may include a message field of 5 bytes, referring to FIG. 11.

Referring to FIG. 11, the message field of the configuration packet CFG may include a 1-bit authentication (AI) flag, and a 1-bit out-of-band (OB) flag.

The authentication flag AI indicates whether the wireless power receiver 1020 supports the authentication function. For example, if the value of the authentication flag AI is '1', it indicates that the wireless power receiver 1020 supports an authentication function or operates as an authentication initiator, if the value of the authentication flag AI is '0', it may indicate that the wireless power receiver 1020 does not support an authentication function or cannot operate as an authentication initiator.

The out-band (OB) flag indicates whether the wireless power receiver 1020 supports out-band communication. For example, if the value of the out-band (OB) flag is '1', the wireless power receiver 1020 instructs out-band communication, if the value of the out-band (OB) flag is '0', it may indicate that the wireless power receiver 1020 does not support out-band communication.

In the configuration phase, the wireless power transmitter 1010 may receive the configuration packet (CFG) of the wireless power receiver 1020 and check whether the wireless power receiver 1020 supports an authentication function and supports out-of-band communication.

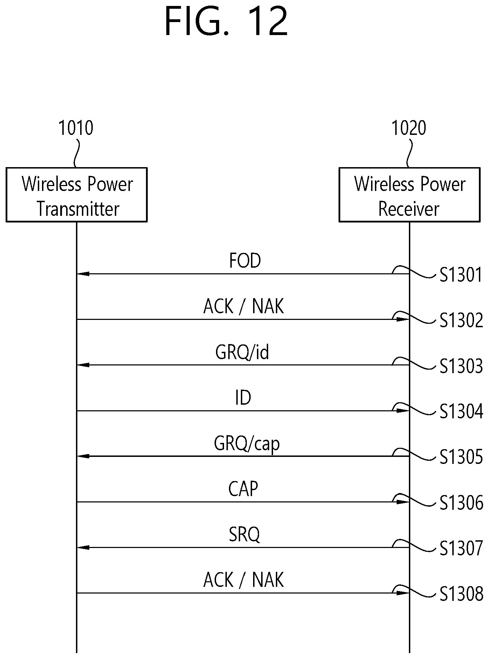

FIG. 12 is a flowchart schematically illustrating a protocol of a negotiation step or a renegotiation step according to an embodiment.

In the negotiation phase or renegotiation phase, the power transfer contract related to the reception/transmission of wireless power between the wireless power receiver and the wireless power transmitter is expanded or changed, or a renewal of the power transfer contract is made that adjusts at least some of the elements of the power transfer contract, or exchange of information for establishing out-band communication may be performed.

In addition, in the negotiation phase or re-negotiation phase, the wireless power transmitter 1010 receives information about the reference quality factor value from the wireless power receiver 1020, the existence of a foreign object can be determined by comparing the reference quality factor value and the measured quality factor value.

Referring to FIG. 12, in the negotiation phase or re-negotiation phase, the wireless power receiver 1020 may transmit a foreign object status packet (FOD) for foreign object detection (FOD) to the wireless power transmitter 1010 (S1301).

The foreign object state packet (FOD) may be packets each including information related to a reference quality factor (Qt(ref)) and a reference resonance frequency. The wireless power transmitter 1010 may check whether a foreign object exists between the wireless power transmitter 1010 and the wireless power receiver 1020 based on information included in the foreign object status packet (FOD).

The wireless power transmitter 1010 may transmit ACK when it is determined that the foreign object does not exist, and transmit NAK when it is determined that the foreign object exists (S1302).

Referring to FIG. 12 again, in the negotiation phase, the wireless power receiver 1020 may receive an identification data packet (ID) and a capabilities data packet (CAP) of the wireless power transmitter 1010 using a general request data packet (GRQ).

The general request packet (GRQ) may have a header value of 0x07 and may include a 1-byte message field. The message field of the general request packet (GRQ) may include a header value of a data packet that the wireless power receiver 1020 requests from the wireless power transmitter 1010 using the GRQ packet. For example, when the wireless power receiver 1020 requests an ID packet of the wireless power transmitter 1010 using a GRQ packet, the wireless power receiver 1020 transmits a general request packet (GRQ/id) including a header value (0x30) of the ID packet of the wireless power transmitter 1010 in the message field of the general request packet (GRQ).

Referring to FIG. 12, in the negotiation phase or renegotiation phase, the wireless power receiver 1020 may transmit a GRQ packet (GRQ/id) requesting the ID packet of the wireless power transmitter 1010 to the wireless power transmitter 1010 (S1303).

The wireless power transmitter 1010 receiving the GRQ/id may transmit the ID packet to the wireless power receiver 1020 (S1304). The ID packet of the wireless power transmitter 1010 includes information on the Manufacturer Code. The ID packet including information on the Manufacturer Code allows the manufacturer of the wireless power transmitter 1010 to be identified.

Referring to FIG. 12, in the negotiation phase or renegotiation phase, the wireless power receiver 1020 may transmit a GRQ packet (GRQ/cap) requesting a capability packet (CAP) of the wireless power transmitter 1010 to the wireless power transmitter 1010 (S1305). The message field of the GRQ/cap may include a header value (0x31) of the capability packet (CAP).

The wireless power transmitter 1010 receiving the GRQ/cap may transmit a capability packet (CAP) to the wireless power receiver 1020 (S1306).

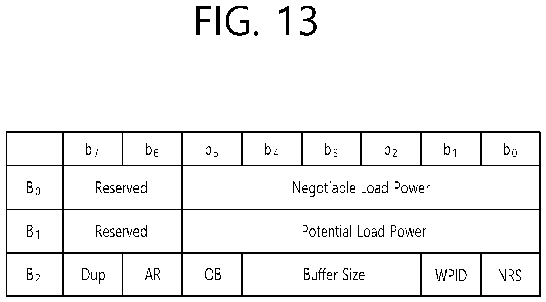

FIG. 13 is a diagram illustrating a message field of a capability packet (CAP) of a wireless power transmitter according to an embodiment.

A capability packet (CAP) according to an embodiment may have a header value of 0x31, and referring to FIG. 13, may include a message field of 3 bytes.

Referring to FIG. 13, a 1-bit authentication (AR) flag and a 1-bit out-of-band (OB) flag may be included in the message field of the capability packet (CAP).

The authentication flag AR indicates whether the wireless power transmitter 1010 supports the authentication function. For example, if the value of the authentication flag AR is '1', it indicates that the wireless power transmitter 1010 supports an authentication function or can operate as an authentication responder, if the value of the authentication flag AR is '0', it may indicate that the wireless power transmitter 1010 does not support the authentication function or cannot operate as an authentication responder.

The out-band (OB) flag indicates whether the wireless power transmitter 1010 supports out-band communication. For example, if the value of the out-band (OB) flag is '1', the wireless power transmitter 1010 instructs out-band communication, if the value of the out-band (OB) flag is '0', it may indicate that the wireless power transmitter 1010 does not support out-band communication.

In the negotiation phase, the wireless power receiver 1020 receives a capability packet (CAP) of the wireless power transmitter 1010, it is possible to check whether the wireless power transmitter 1010 supports an authentication function, supports out-of-band communication, and the like.

And, according to FIG. 12, in the negotiation phase or re-negotiation phase, the wireless power receiver 1020 may use at least one specific request packet (SRQ, Specific Request data packet) to update the elements of the Power Transfer Contract related to the power to be provided in the power transfer phase, the negotiation phase or the re-negotiation phase may be ended (S1307).

The wireless power transmitter 1010 may transmit only ACK, only ACK or NAK, or only ACK or ND in response to the specific request packet SRQ according to the type of the specific request packet SRQ (S1308).

In the above-described ping phase, configuration phase, and negotiation/renegotiation phase, a data packet or message exchanged between the wireless power transmitter 1010 and the wireless power receiver 1020 may be transmitted/received through in-band communication.

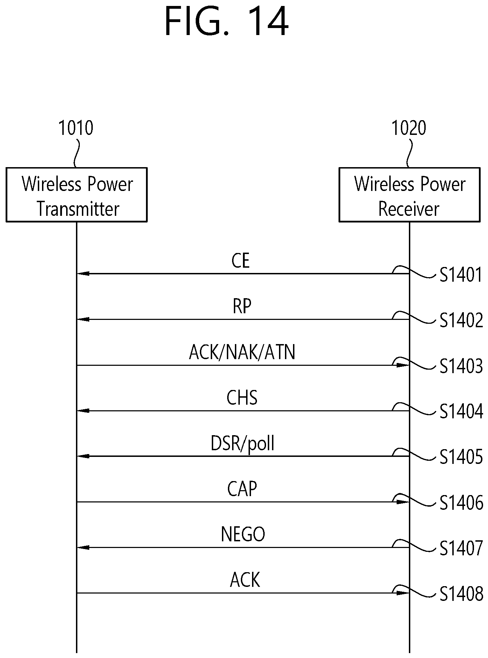

FIG. 14 is a flowchart schematically illustrating a protocol of a power transmission step according to an embodiment.

In the power transfer phase, the wireless power transmitter 1010 and the wireless power receiver 1020 may transmit/receive wireless power based on a power transfer contract.

Referring to FIG. 14, in the power transfer phase, the wireless power receiver 1020 transmits a control error data packet (CE) including information on the difference between the actual operating point and the target operating point to the wireless power transmitter 1010 (S 1401).

Also, in the power transfer phase, the wireless power receiver 1020 transmits a received power packet (RP, Received Power data packet) including information on the received power value of the wireless power received from the wireless power transmitter 1010 to the wireless power transmitter 1010 (S1402).

In the power transfer phase, the control error packet (CE) and the received power packet (RP) are data packets that are repeatedly transmitted/received according to timing constraints required for wireless power control.

The wireless power transmitter 1010 may control the level of wireless power transmitted based on the control error packet (CE) and the received power packet (RP) received from the wireless power receiver 1020.

The wireless power transmitter 1010 may respond with an 8-bit bit pattern such as ACK, NAK, ATN, etc. to the received power packet (RP) (S1403).

For a received power packet (RP/0) with a mode value of 0, when the wireless power transmitter 1010 responds with ACK, it means that power transmission can continue at the current level.

For a received power packet (RP/0) with a mode value of 0, when the wireless power transmitter 1010 responds with NAK, it means that the wireless power receiver 1020 should reduce power consumption.

For a received power packet (RP/1 or RP/2) having a mode value of 1 or 2, when the wireless power transmitter 1010 responds with ACK, it means that the wireless power receiver 1020 has accepted the power correction value included in the received power packet (RP/1 or RP/2).

For a received power packet (RP/1 or RP/2) having a mode value of 1 or 2, when the wireless power transmitter 1010 responds with NAK, it means that the wireless power receiver 1020 does not accept the power correction value included in the received power packet RP/1 or RP/2.

About Receive Power Packet (RP), when the wireless power transmitter 1010 responds with ATN, it means that the wireless power transmitter 1010 requests permission for communication.

The wireless power transmitter (1010) and the wireless power receiver (1020) can control the transmitted/received power level based on a control error packet (CE), a received power packet (RP), and a response to the received power packet (RP).

Also, in the power transfer phase, the wireless power receiver 1020 transmits a charge status data packet (CHS) including information on the charge state of the battery to the wireless power transmitter 1010 (S1404). The wireless power transmitter 1010 may control the power level of the wireless power based on the information on the state of charge of the battery included in the state of charge packet (CHS).

Meanwhile, in the power transfer phase, the wireless power transmitter 1010 and/or the wireless power receiver 1020 may enter a renegotiation phase to renew the power transfer contract.

In the power transfer phase, when the wireless power transmitter 1010 wants to enter the renegotiation phase, the wireless power transmitter 1010 responds to the received power packet (RP) with ATN. In this case, the wireless power receiver 1020 may transmit a DSR/poll packet to the wireless power transmitter 1010 to give the wireless power transmitter 1010 an opportunity to transmit a data packet (S 1405).

When the wireless power transmitter 1010 transmits a performance packet (CAP) to the wireless power receiver 1020 in response to the DSR/poll packet (S1406), the wireless power receiver 1020 transmits a renegotiation packet (NEGO) requesting the progress of the re-negotiation phase to the wireless power transmitter 1010 (S1407), when the wireless power transmitter 1010 responds with an ACK to the renegotiation packet (NEGO) (S1408), the wireless power transmitter 1010 and the wireless power receiver 1020 enter a re-negotiation phase.

In the power transfer phase, when the wireless power receiver 1020 wants to enter the re-negotiation phase, the wireless power receiver 1020 transmits a renegotiation packet (NEGO) requesting the progress of the re-negotiation phase to the wireless power transmitter 1010 (S1407), when the wireless power transmitter 1010 responds with an ACK to the renegotiation packet (NEGO) (S1408), the wireless power transmitter 1010 and the wireless power receiver 1020 enter a re-negotiation phase.

Hereinafter, a foreign object detection method during power transfer will be described.

Various methods can be used as a foreign object detection method during power transmission, a method of stopping power transmission for a short period of time and performing foreign object detection within a short period of time during which power transmission is stopped may be used. The short time during which power transmission is stopped can be referred to as slot time, a method of stopping power transmission during the slot time and detecting a foreign object may be referred to as foreign object detection using a slot, Slotted FOD, or Slot FOD. Hereinafter, it is collectively referred to as Slotted FOD.

Since the slotted FOD stops power transmission for a short time, the wireless power reception can be continuously maintained without a large reduction in the rectified voltage of the wireless power receiver during the time of detecting the foreign object, since it does not affect the operation of the wireless power receiver, there is an advantage that the operation of the wireless power receiver can be continuously maintained.

Among Slotted FODs, in the power transfer phase, there is a Slotted Q FOD in which a wireless power transmitter stops power transmission for a short time and detects a foreign object from a change in current and/or voltage that is naturally reduced in a resonant circuit including a primary coil.

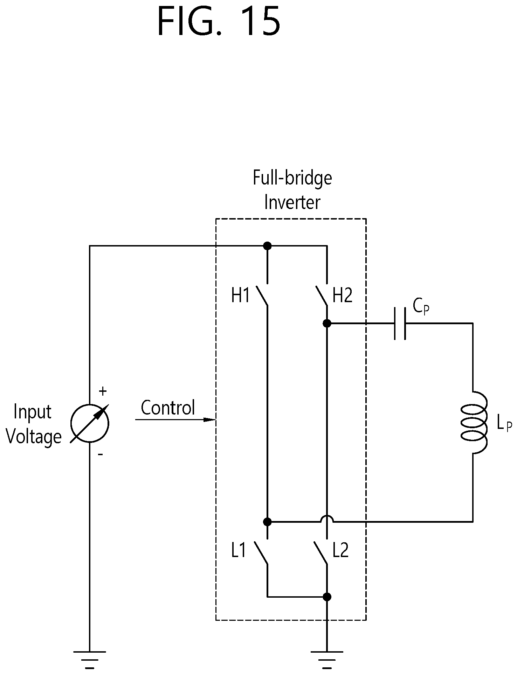

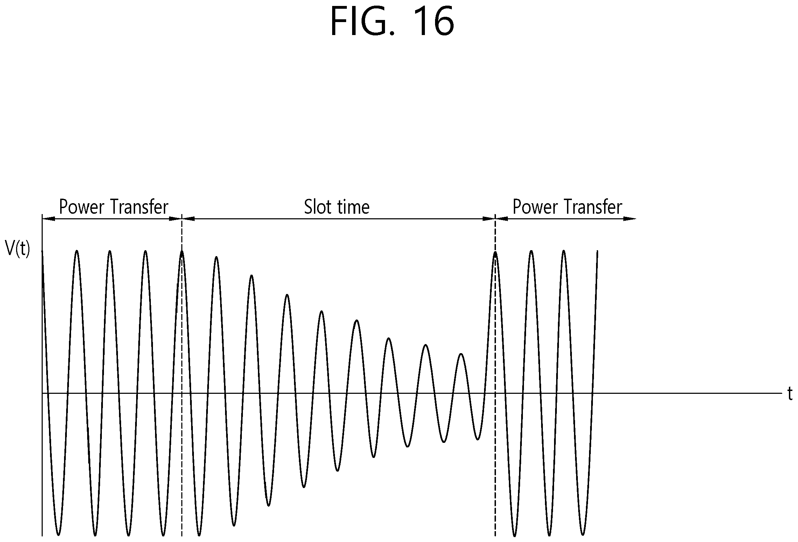

FIG. 15 is a schematic circuit diagram of a wireless power transmitter supporting a foreign object detection method by Slotted Q FOD, and FIG. 16 is a graph schematically showing a voltage attenuation waveform of a primary coil during a slot time.

Referring to FIG. 15, the power conversion circuit of the wireless power transmitter may be outlined as an LC circuit including a full bridge inverter including four switches H1, H2, L1, and L2.

In the power transfer phase, the wireless power transmitter receives power from a power supply source expressed as an input voltage and provides wireless power to the wireless power receiver through the primary coil Lp. At this time, the four switches (H1, H2, L1, L2) of the full bridge inverter are controlled to form a circuit consisting of an input voltage - a capacitor (Cp) - a primary coil (Lp). Referring to FIG. 16, a sine wave voltage having a substantially constant peak value may be applied to the primary coil Lp in the power transfer phase.

When forming a slot time for foreign object detection, the full bridge inverter has H1 and H2 switches open, when the L1 and L2 switches are switched to the closed state, the wireless power transmitter forms a closed-loop resonant circuit consisting of a capacitor (Cp) and a primary coil (Lp), the supply of power to the resonant circuit is cut off.

Referring to FIG. 16, during the slot time, the voltage (or current) of the primary coil Lp oscillates in a waveform having a resonant frequency according to the capacitance of the capacitor Cp and the inductance characteristics of the primary coil Lp, it is gradually attenuated by the resistance affecting the resonant circuit. The quality factor (Q factor) of the LC resonant circuit can be measured from the damping ratio (or damping coefficient) of the voltage (or current). And, if a foreign object adjacent to the wireless power transmission device exists, since the Q factor is generally measured lower, the presence of a foreign object can be determined from the Q factor measured within the slot time or the voltage (or current) waveform of the primary coil Lp measured within the slot time.

As described above, the foreign object detection method by Slotted Q FOD is a method of cutting off external power during the slot time, forming a resonance circuit including a primary coil, measuring a Q factor from a voltage (or current) waveform of the primary coil Lp during a slot time, and detecting the presence of a foreign object based on this.

However, in the power transfer phase, the current flowing through the primary coil Lp and the voltage applied to the primary coil Lp continuously change with time as a sine wave. Therefore, according to the start time of the slot time, the current flowing through the primary coil Lp and the voltage applied to the primary coil Lp may vary, this results in a voltage waveform or current waveform of the primary coil (Lp) stage being different each time during the slot time. In addition, since the Q factor measured depending on the voltage waveform or current waveform of the primary coil (Lp) stage is also inconsistent, reliability of foreign object detection results by Slotted Q FOD may be weakened.

Hereinafter, a method for more accurately measuring a Q factor measured within a slot time and a foreign object detection method using the same will be described.

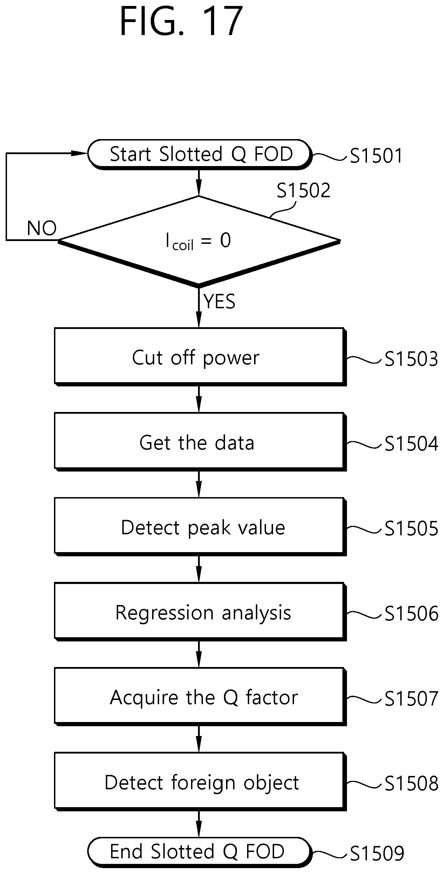

FIG. 17 is a flowchart illustrating a foreign object detection method according to an embodiment.

Referring to FIG. 17, when the Slotted Q FOD starts (S1501), the communication/control circuit of the wireless power transmitter detects the time when the current of the primary coil (Lp) becomes 0 (S 1502).

The time point at which the current in the primary coil (Lp) becomes zero may be a time point when the value of the AC current flowing in the primary coil Lp is converted from a positive value to a negative value or a time point when the value is converted from a negative value to a positive value.

If the wireless power transmitter includes a configuration capable of monitoring the current value of the primary coil (Lp), the communication/control circuit of the wireless power transmitter can receive the current value of the primary coil (Lp) from the above configuration and can easily detect the point in time when the current of the primary coil (Lp) becomes zero.

However, if the wireless power transmitter does not have a configuration capable of monitoring the current value of the primary coil (Lp), the communication/control circuit of the wireless power transmission device may detect a time point having a phase difference of 90 degrees from the time point at which the voltage value of the primary coil Lp becomes 0 as the time point at which the current in the primary coil Lp becomes 0. This is because the voltage and current of the primary coil Lp have a phase difference of 90 degrees.

The communication/control circuit of the wireless power transmitter cuts off power transmitted to the primary coil Lp in the power transfer phase when the current of the primary coil Lp becomes zero (S1503). For example, as described with reference to FIG. 15, the communication/control circuit controls the four switches (H1, H2, L1, L2) of the full bridge inverter, constitutes a closed-loop resonant circuit composed of a capacitor Cp-the primary coil Lp and can cut off power transmitted to the primary coil Lp. Or, for example, controlling the power transmitted to the primary coil Lp in the power transfer phase to be OFF, a closed-loop resonant circuit composed of a capacitor Cp and a primary coil Lp may be configured to block power transmitted to the primary coil Lp.

When the power transmitted to the primary coil (Lp) is cut off in the power transfer phase, the slot time starts. Therefore, the slot time starts at the time when the current of the primary coil Lp becomes zero. According to this embodiment, since the starting point of the slot time for the Slotted Q FOD is maintained at the point at which the current of the primary coil Lp becomes 0, a more consistent and reliable Q factor can be obtained.

The communication/control circuit of the wireless power transmitter acquires data on the voltage value across the primary coil (Lp) or the current value flowing through the primary coil (Lp) during the slot time (S1504).

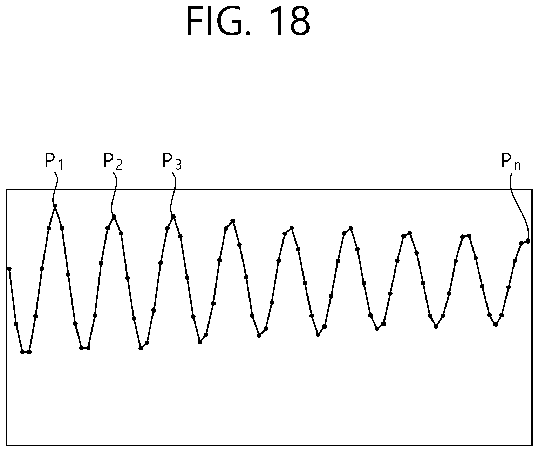

FIG. 18 is a diagram showing an example of data acquired in step S 1504.

Referring to FIG. 18, the communication/control circuit of the wireless power transmitter records the voltage value across the primary coil Lp or the current value flowing through the primary coil Lp at various times within the slot time.

Thereafter, the communication/control circuit of the wireless power transmitter detects peak values of the voltage value or current value of the primary coil (Lp) within the slot time based on the data obtained in step S1504 (S1505).

Referring to FIG. 18, the communication/control circuit of the wireless power transmitter may detect peak values $(P_1, P_2, P_3, ..., P_n)$ of the attenuation waveform based on the values of the data obtained in step S1504.

Thereafter, the communication/control circuit of the wireless power transmitter may perform regression analysis based on the peak values detected in step S1505 (S1506).

However, the communication/control circuit of the wireless power transmitter may obtain effective peak values to be subjected to regression analysis among the peak values detected in step S1505.

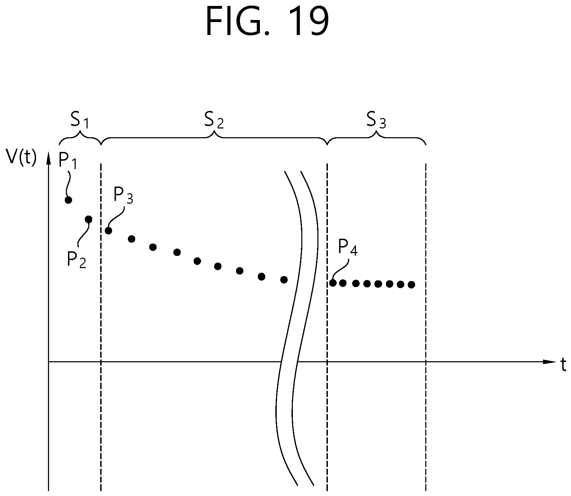

FIG. 19 is a diagram for explaining a method of obtaining effective peak values according to an exemplary embodiment.

Referring to FIG. 19, among the detected peak values $(P_1, P_2, P_3, ..., P_n)$, the communication/control circuit of the wireless power transmitter may obtain effective peak values excluding the peak values $P_1$ and $P_2$ of the initial period $S_1$.

Theoretically, since the peak values detected within the slot time are values measured in the RLC resonance circuit, they should form a specific exponential function, peak values derived from various experiments generally have an exponential trend, but it is not defined as a single exponential function. In particular, among the peak values detected within the slot time, the peak value of the initial section $(S_1)$ tended to adversely affect the regression analysis result. It is presumed that after the resonance circuit is configured, other influences other than the characteristics of the resonance circuit are initially applied to the voltage value or current value of the primary coil Lp in a transient state.

Thus, in this embodiment, among the detected peak values $(P_1, P_2, P_3, ..., P_n)$, a method of obtaining effective peak values excluding the peak values $P_1$ and $P_2$ of the initial period $S_1$ is proposed.

The length of the initial section $S_1$ may be determined differently according to embodiments. For example, only the first peak value $P_1$ may be included in the initial period $S_1$, or two or more first peak values may be included.

In addition, among the detected peak values $(P_1, P_2, P_3, ..., P_n)$, the communication/control circuit of the wireless power transmitter may obtain an effective peak value except for the peak value $P_4$ of the latter period $S_3$.

The second half section $(S_3)$ may be a section in which the deviation of the peak values $(P_4)$ is less than a certain level. Alternatively, the second half section $S_3$ may be a section in which the peak values $P_4$ have values substantially close to zero.

Since the peak values $(P_4)$ of the latter period $(S_3)$ may also act as factors that adversely affect the regression analysis result, in this embodiment, a method of obtaining an effective peak value excluding the peak value $P_4$ of the second half section $S_3$ among the detected peak values $P_1, P_2, P_3, ..., P_n$ is proposed.

Alternatively, the second half section $S_3$ may be determined according to the number of acquired valid peak values. For example, when 15 are predetermined as the number of valid peak values for regression analysis, a section in which peak values exist after 15 valid peak values are obtained may be a second half section $S_3$.

Meanwhile, for continuity of providing wireless power to the wireless power receiver, the slot time is preferably formed within 100 μs. In order to reduce the slot time as much as possible, after a preset number of effective peak values are obtained, the slot time is ended and wireless power transmission may be resumed.

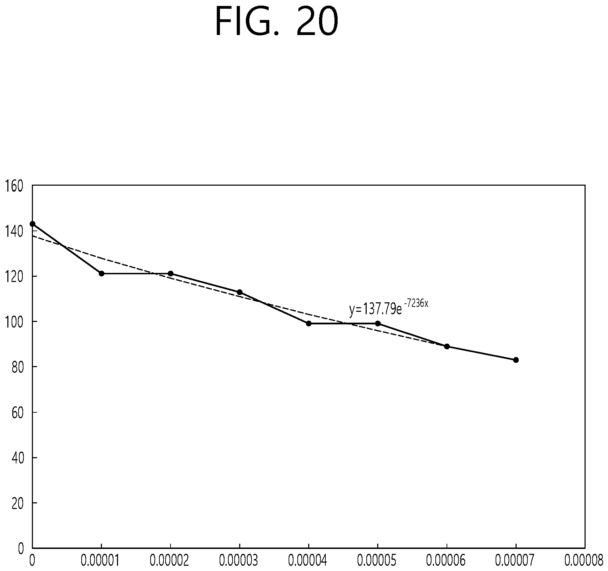

FIG. 20 is a diagram for explaining a regression analysis method according to an embodiment.

The communication/control circuit of the wireless power transmitter may derive an exponential function that is an envelope of effective peak values through regression analysis based on a plurality of effective peak values.

FIG. 20 shows an example in which an exponential function of $y = 137.79e^{-7236x}$ is derived based on 9 effective peak values.

When an exponential function, which is an envelope of effective peak values, is derived, the communication/control circuit of the wireless power transmitter may obtain a Q factor based on the exponential function (S 1507).

The exponential function can be expressed as $N(t) = N_0 e^{-t/\tau}$, and in the exponential function shown in FIG. 20, a time constant $(\tau)$ becomes 1/7236.

The correlation between the Q factor, the damping ratio ($\zeta$), and the time constant ($\tau$) can be expressed by the following equation.

【 Equation 1】

$$Q = \frac{1}{\zeta} = \frac{w_0}{2\alpha} = \frac{\tau \cdot w_0}{2} = \pi\tau f_0$$

When the f0 value is 111000 (Hz), the Q factor value is calculated to be about 48.17 based on the exponential function of FIG. 20d.

As such, the communication/control circuit of the wireless power transmitter may calculate and obtain the value of the Q factor using the time constant $\tau$ of the exponential function derived in step S1506.

The communication/control circuit of the wireless power transmitter may detect a foreign object between the wireless power transmitter and the wireless power receiver using the acquired Q factor (S1508).

For example, the communication/control circuit of the wireless power transmitter may compare the Q factor value obtained in step S 1507 with a previously stored Q factor value to estimate the presence of a foreign object. That is, as the Q factor value acquired in step S1507 is lower than the previously stored Q factor value, the possibility of existence of a foreign object increases. Therefore, the communication / control circuit of the wireless power transmitter when the difference between the pre-stored Q factor value and the Q factor value obtained in step S 1507 is greater than the threshold value, it can be determined that a foreign object exists.

The pre-stored Q factor value may be a pre-measured Q factor value in the absence of a foreign object or a Q factor value received from the wireless power receiver.

The communication/control circuit of the wireless power transmitter may transmit information (data packet or response pattern) according to the detection result of the foreign object to the wireless power receiver, and terminate the Slotted Q FOD (S1509).

As described above, according to the present embodiment, in performing Slotted Q FOD, by setting the starting point of the slot time to the point at which the current of the primary coil Lp becomes, it enables a more consistent and reliable Q factor to be obtained.

Also, according to this embodiment, in performing Slotted Q FOD, an exponential function, which is the envelope of effective peak values, is derived through regression analysis using a plurality of effective peak values, and a Q factor is obtained based on this, it enables more reliable Q factor acquisition.

Also, according to this embodiment, in performing Slotted Q FOD, since the effective peak values are selected excluding the peak values of the early section and / or the latter section among the obtained peak values, it enables more reliable Q factor acquisition.

Meanwhile, in the following description, a method of obtaining a reference Q factor value serving as a comparison standard of the Q factor value obtained when determining the existence possibility of a foreign object in step S 1508 will be described.

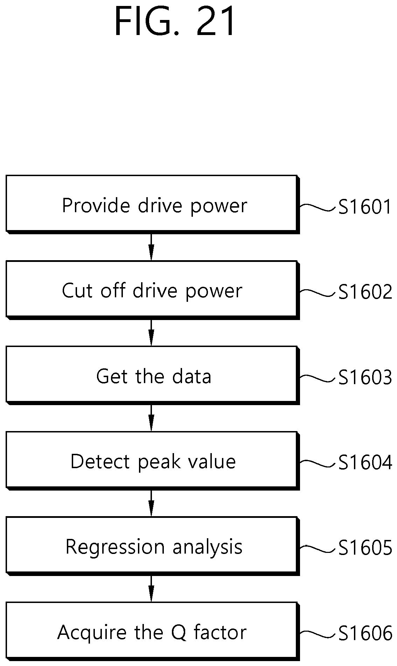

FIG. 21 is a flowchart for explaining a method of obtaining a reference Q factor according to an embodiment.

The method for obtaining a reference Q factor described with reference to FIG. 21 is performed before transmitting wireless power to a wireless power receiver, for example, the ping step may be performed in a state in which an object does not exist in the operating volume of the wireless power transmitter, that is, above the primary coil. Therefore, the method of acquiring the reference Q factor according to the present embodiment may be performed before transmitting a digital ping to the wireless power receiver.

The communication/control circuit of the wireless power transmitter provides driving power to the primary coil in order to obtain a reference Q factor of the wireless power transmitter (S 1601).

The driving power may be at least one pulse signal.

After providing at least one pulse signal to the primary coil, the communication/control circuit blocks driving power (S 1602).

The communication/control circuit may constitute a closed-loop resonant circuit composed of a capacitor Cp and a primary coil Lp while cutting off driving power. For example, as described above with reference to FIG. 15, the communication/control circuit controls the four switches H1, H2, L1, and L2 of the full bridge inverter to configure a closed-loop resonant circuit composed of a capacitor Cp-primary coil Lp.

Due to the applied driving power, in the closed-loop resonant circuit composed of capacitor Cp-primary coil Lp, the voltage (or current) of the primary coil Lp oscillates in a waveform having a resonant frequency according to the capacitance of the capacitor Cp and the inductance characteristics of the primary coil Lp, it is gradually attenuated by the resistance affecting the resonant circuit.

The communication/control circuit of the wireless power transmitter acquires data on the voltage value across the primary coil (Lp) or the current value flowing through the primary coil (Lp) (S1603).

In the foregoing embodiment, similar to what was described with reference to FIG. 18, the communication/control circuit of the wireless power transmitter records the voltage value across the primary coil (Lp) or the current value flowing through the primary coil (Lp) at various points in time within the slot time.

Thereafter, the communication/control circuit of the wireless power transmitter detects peak values of the voltage value or current value of the primary coil Lp based on the data obtained in step S1603 (S1604).

In the foregoing embodiment, similar to that described with reference to FIG. 18, the communication/control circuit of the wireless power transmitter may detect peak values $P_1$, $P_2$, $P_3$, ..., $P_n$ of the attenuation waveform.

Thereafter, the communication/control circuit of the wireless power transmitter may perform regression analysis based on the peak values detected in step S1604 (S1605).

However, the communication/control circuit of the wireless power transmitter may obtain effective peak values to be subjected to regression analysis among the peak values detected in step S 1604.

In the foregoing embodiment, similarly to that described with reference to FIG. 19, among the detected peak values ($P_1$, $P_2$, $P_3$, ..., $P_n$), the communication/control circuit of the wireless power transmitter may obtain an effective peak value excluding the peak values $P_1$ and $P_2$ of the initial period $S_1$ and/or the peak value $P_4$ of the second period $S_3$. Since specific details thereof have been described with reference to FIG. 19, additional description thereof will be omitted.

The communication/control circuit of the wireless power transmitter may derive an exponential function that is an envelope of effective peak values through regression analysis based on a plurality of effective peak values.

When an exponential function, which is an envelope of effective peak values, is derived, the communication/control circuit of the wireless power transmitter may obtain a reference Q factor based on the exponential function (S1606).

Since the method of calculating the Q factor using the time constant $\tau$ of the exponential function has been described with reference to FIG. 20 and the like, further description thereof will be omitted.

Since the method for obtaining the reference Q factor according to the present embodiment uses at least one pulse signal as driving power, it may be called Impulse Q, and the obtained reference Q factor may be called Impulse Q factor.

The communication/control circuit of the wireless power transmitter may detect an operating volume, that is, an object existing above the primary coil, in the ping phase using the obtained reference Q factor.

For example, the communication/control circuitry of a wireless power transmitter can estimate the presence of an object existing in the action space by comparing the obtained reference Q factor with a previously stored Q factor (a Q factor measured in a state where no object exists in the action space). That is, as the obtained reference Q factor value is lower than the pre-stored Q factor value, the probability of existence of the object increases. Therefore, when the difference between the pre-stored Q factor value and the reference Q factor value obtained in step S 1606 is greater than the threshold value, the communication/control circuit of the wireless power transmitter may determine that an object exists in the operating space.

In addition, by comparing the Q factor obtained through the Slotted Q FOD performed in the power transfer phase with the reference Q factor value obtained in step S 1606, the communication/control circuit of the wireless power transmitter may detect a foreign object existing between the wireless power transmitter and the wireless power receiver.

Hereinafter, a foreign object detection method based on power loss in the power transfer phase will be described.

When a wireless power transmitter transmits wireless power to a wireless power receiver using a magnetic field, if a foreign object exists around the wireless power transmitter, some of the magnetic field is absorbed by the foreign object. Accordingly, some of the wireless power transmitted by the wireless power transmitter is absorbed by the foreign object, and the rest is supplied to the wireless power receiver.

From the viewpoint of power transmission efficiency, transmission power loss occurs as much as the power or energy absorbed by the foreign object. In this way, since a causal relationship can be established between the existence of a foreign object and power loss (Ploss), the wireless power transmitter may detect a foreign object through how much power loss occurs.

On the other hand, the power transmission characteristics between the wireless power transmitter and the wireless power receiver depend on the unique characteristics of the environment or device that transmits the wireless power. The wireless power transmitter and the wireless power receiver may use power calibration at the start time of wireless power transmission in order to determine power transmission characteristics in a currently given wireless charging environment.

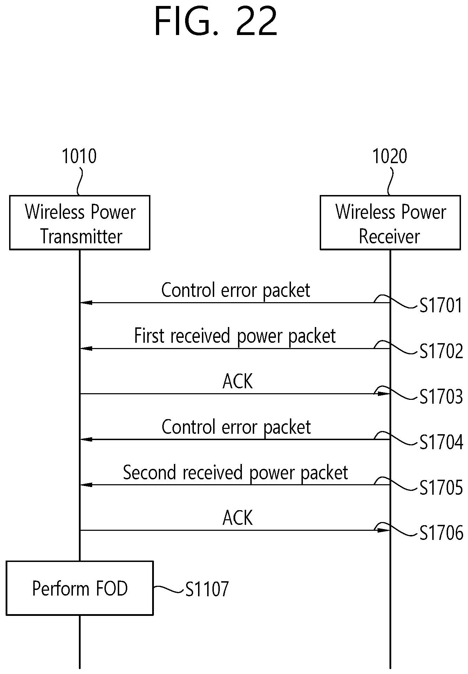

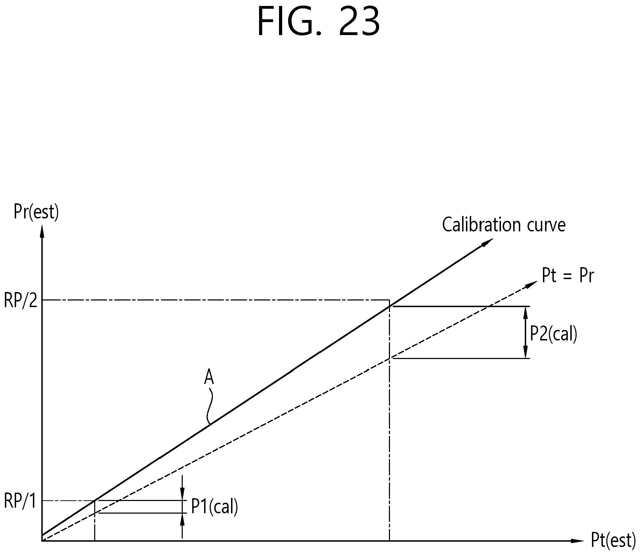

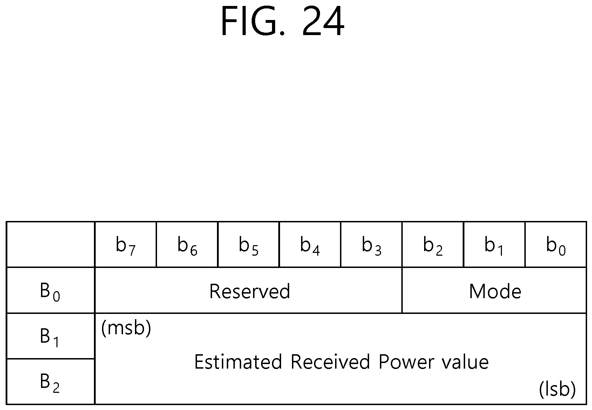

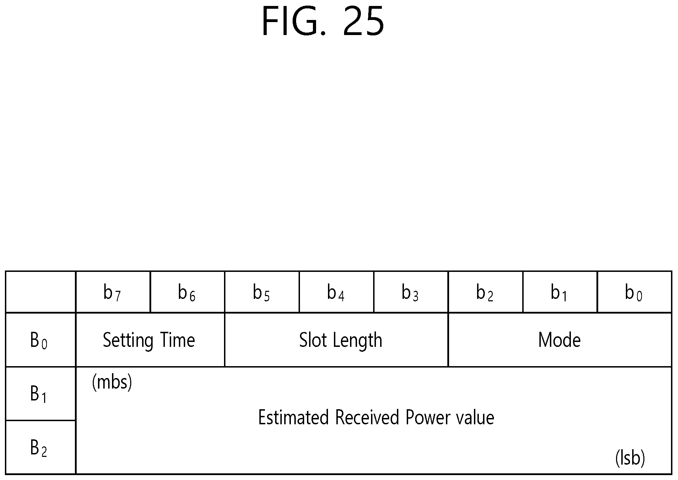

FIG. 22 is a flowchart for explaining a double-point power calibration method, FIG. 23 is a graph showing an example of a power calibration curve by a double-point power calibration method, FIG. 24 is a diagram showing a format of a message field of a received power packet according to an example, FIG. 25 is a diagram illustrating a format of a message field of a received power packet according to another example.

Referring to FIG. 22, at the start of the power transfer phase, a power calibration protocol is performed, the wireless power receiver 1020 transmits the first received power packet (RP / 1) and the second received power packet (RP / 2), it allows the wireless power transmitter 1010 to configure a double-point power calibration curve.

More specifically, the wireless power receiver 1020 transmits a control error packet (CE) to the wireless power transmitter (S1701), it transmits the first received power packet (RP / 1) including information on the first calibration data point to the wireless power transmitter 1010 (S 1702).

The control error packet contains the control error value. The control error value includes information about a deviation between a target operating point and an actual operating point of the wireless power receiver 1020. For example, if the control error value is positive, it means that the actual operating point is lower than the target operating point, the wireless power transmitter 1010 receiving this can increase the power of the wireless power to be transmitted. Conversely, if the control error value is negative, it means that the actual operating point is higher than the target operating point. The wireless power transmitter 1010 receiving this may lower the power of the wireless power to be transmitted.

Referring to FIG. 24 or 25, the first received power packet (RP/1) includes a Mode field and an Estimated Received Power Value field. Through the value (e.g., 1) of the mode field of the first received power packet (RP / 1), the wireless power transmitter 1010 can confirm that the received power packet (RP) received from the wireless power receiver 1020 is the first received power packet (RP / 1) including information on the first calibration data point, and it can check the first calibration data point through the value of the estimated received power value field of the first received power packet RP/1.

The first calibration data point is the starting point of the power calibration curve, it may be a power level corresponding to about 10% of a reference power level of a power transfer contract established in the negotiation phase.

The wireless power transmitter 1010 determines whether the wireless power receiver 1020 has reached a desired target operating point based on the control error value included in the control error packet, it responds with ACK or NAK to the first received power packet (RP/1) (S1703). More specifically, the wireless power transmitter 1010 determines whether the power level is stabilized at the first calibration data point based on the control error value. For example, the wireless power transmitter 1010 determines that the power level is stabilized and the wireless power receiver 1020 has reached a desired target operating point when the control error value is less than 3, it may respond with an ACK to the first received power packet (RP/1). If the control error value is less than 3, it is determined that the power level has not been stabilized and the wireless power receiver 1020 has not reached the desired target operating point. The wireless power transmitter 1010 may respond with NAK to the first received power packet (RP/1).

The wireless power receiver 1020 continues to transmit the first received power packet (RP/1) until receiving an ACK from the wireless power transmitter 1010 (S1702). In addition, the wireless power receiver 1020 also repeatedly transmits a control error packet to the wireless power transmitter 1010 so that the power level can be stabilized at the first calibration data point (S1701).

After the wireless power receiver 1020 receives the ACK for the first received power packet (RP/1) from the wireless power transmitter 1010 (S1703), the control error packet is transmitted to the wireless power transmission device (S1704), a second received power packet (RP/2) including information on a second calibration data point is transmitted to the wireless power transmitter 1010 (S1705).

The second received power packet (RP/2) also includes a Mode field and an Estimated Received Power Value field (see FIG. 24 or 25). Through the value (e.g., 0) of the mode field of the second received power packet (RP / 2), the wireless power transmitter 1010 can be confirmed that the received power packet (RP) received from the wireless power receiver 1020 is a second received power packet (RP / 2) including information on the second calibration data point, the second calibration data point may be identified through the value of the estimated received power value field of the second received power packet (RP/2).

The second calibration data point is a point for constructing a power calibration curve, it may be a power level close to the reference power level of the power transfer contract established in the negotiation phase.

The wireless power transmitter 1010 determines whether the wireless power receiver 1020 has reached a desired target operating point based on the control error value included in the control error packet, it responds with ACK or NAK to the second received power packet (RP/2) (S1706). More specifically, the wireless power transmitter 1010 determines whether the power level is stabilized at the second calibration data point based on the control error value. For example, the wireless power transmitter 1010 determines that the power level is stabilized and the wireless power receiver 1020 has reached a desired target operating point when the control error value is less than 3, it may respond with ACK to the second received power packet (RP/2) (S 1706). If the control error value is less than 3, it is determined that the power level has not been stabilized and the wireless power receiver 1020 has not reached the desired target operating point. The wireless power transmitter 1010 may respond with NAK to the second received power packet (RP/2).

The wireless power receiver 1020 continues to transmit the second received power packet (RP/2) until receiving an ACK from the wireless power transmitter 1010 (S 1705). In addition, the wireless power receiver 1020 also repeatedly transmits a control error packet to the wireless power transmitter 1010 so that the power level can be stabilized at the second calibration data point (S1704).

After the power level is stabilized at the second calibration data point and an ACK for the second received power packet (RP/2) is received from the wireless power transmitter 1010 (S 1706), the wireless power receiver 1020 and the wireless power transmitter 1010 enter a normal power transmission mode. Based on the 1st received power packet (RP/1) and the 2nd received power packet (RP/2) that transmitted the ACK, the wireless power transmitter 1010 constructs a power calibration curve (see FIG. 23), using this, foreign object detection based on transmission power loss can be performed (S 1707).

More specifically, the wireless power transmitter 1010 receives a received power packet (eg, RP/0 having a mode field value of 0) from the wireless power receiver 1020 during power transmission, it checks the received power value received by the wireless power receiver 1020 through the received power packet, if the difference between the calibrated power value calculated by applying the transmit power value to the power calibration curve and the received power value confirmed through the received power packet is greater than the threshold, it can be assumed that power loss is caused by a foreign object.

Referring to FIG. 23, a power calibration curve constructed by the above-described double-point power calibration method will be described.

The wireless power transmitter 1010 configures a power calibration curve (calibration curve, A) based on the first received power packet (RP/1) and the second received power packet (RP/2) transmitted with ACK.

The predicted value of transmit power is Pt(est), the predicted value of receive power is Pr(est), the actual transmit power value is Pt, the actual receive power value is Pr, when it is confirmed that there is no foreign object between the wireless power transmitter and the wireless power receiver through foreign object detection (pre-power FOD) before power transmission, the following [Equation 2] is established.

$$【\ \text{Equation 2}】$$

$$Pt(est)+\delta Pt=Pt=\mathrm{Pr}=\mathrm{Pr}(est)-\delta\mathrm{Pr}$$

Here, $\delta$Pt is an prediction error value of transmission power, and may include a power loss value of the wireless power transmitter itself. $\delta$Pr is a prediction error value of received power, and may include a power loss value of the wireless power receiver itself.

Based on [Equation 2], the calibrated power value P(cal) can be calculated by the following [Equation 3].

$$【\ \text{Equation 3}】$$

$$P(cal)=\delta Pt+\delta\mathrm{Pr}=\mathrm{Pr}(est)-Pt(est)$$

Therefore, if RP / 1 (first calibration data point) and RP / 2 (second calibration data point) are substituted into [Equation 3], each calibrated power value can be expressed as the following [Equation 4].

$$【\ \text{Equation 4}】$$

$$P1(cal)=RP/1-Pt1(est)$$
$$P2(cal)=RP/2-Pt2(est)$$

That is, if it is confirmed by the pre-power FOD that there is no foreign object, the same relationship as Equations 2 to 4 is established, a calibration curve based on Equations 2 to 4 may be shown as a graph (A) as shown in FIG. 23.

An example of constructing a power calibration curve with two calibration data points has been described, but depending on the embodiment, a power calibration curve may be configured with three or more calibration data points using additional RP/2, and foreign object detection may be performed based on this.

However, the foreign object detection method based on the loss of transmission power described with reference to FIGS. 22 to 25 is assumed that there is no foreign object between the wireless power transmitter 1010 and the wireless power receiver 1020 during the power calibration process (S1701 to S1707).

If at least some steps of the power calibration process are performed in a state where a foreign object exists between the wireless power transmitter 1010 and the wireless power receiver 1020, the wireless power transmitter 1010 cannot perform accurate foreign object detection.

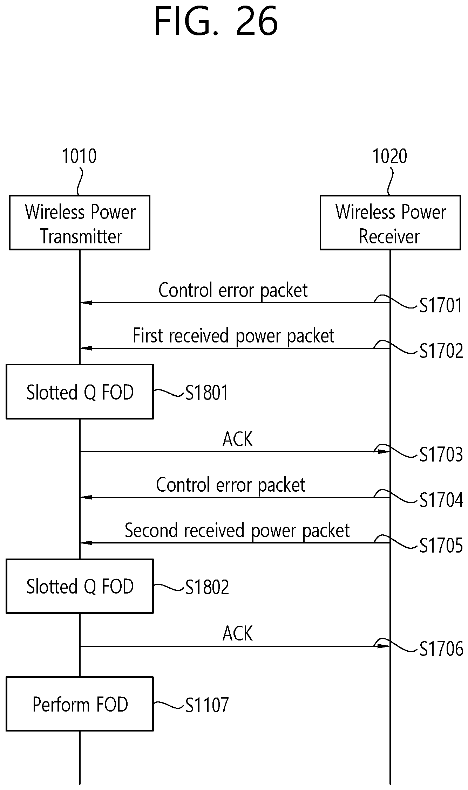

FIG. 26 is a flowchart illustrating an improved power calibration method according to an embodiment.

Referring to FIG. 26, compared to the embodiment described with reference to FIG. 25, after receiving the first received power packet (RP/1), the wireless power transmitter 1010 performs Slotted Q FOD (S1801). Since the specific details of the Slotted Q FOD have been described above with reference to FIGS. 15 to 20, an additional description thereof will be omitted.

After receiving the first received power packet (RP/1), the wireless power transmitter 1010 performs Slotted Q FOD (S1801), whether or not a foreign object exists between the wireless power transmitter 1010 and the wireless power receiver 1020 may be checked.

According to an embodiment, the wireless power transmitter 1010 performs Slotted Q FOD multiple times after receiving the first received power packet (RP/1), it is possible to determine whether a foreign object exists by using the average of a plurality of measured Q factor values or the average of values excluding the maximum and minimum values among the plurality of measured Q factor values.

As a result of performing Slotted Q FOD, the wireless power transmitter 1010 estimates that there is no foreign object, and if it is determined that the power level is stabilized at the first calibration data point based on the control error value, it may respond with ACK to the first received power packet (RP/1) (S1703).

As a result of performing Slotted Q FOD, the wireless power transmitter 1010 determines that a foreign object exists or that the power level is not stabilized at the first calibration data point based on the control error value, it may respond with NAK to the first received power packet (RP/1).

The wireless power transmitter 1010 performs Slotted Q FOD even after receiving the second received power packet (RP/2) (S1802), whether or not a foreign object exists between the wireless power transmitter 1010 and the wireless power receiver 1020 may be checked.

According to the embodiment, the wireless power transmitter 1010 performs Slotted Q FOD multiple times after receiving the second received power packet (RP/2), it is possible to determine whether a foreign object exists by using the average of a plurality of measured Q factor values or the average of values excluding the maximum and minimum values among the plurality of measured Q factor values.

As a result of performing Slotted Q FOD, the wireless power transmitter 1010 estimates that there is no foreign object, and if it is determined that the power level is stabilized at the second calibration data point based on the control error value, it may respond with ACK to the second received power packet (RP/2) (S 1706).

As a result of performing Slotted Q FOD, the wireless power transmitter 1010 determines that a foreign object exists or that the power level is not stabilized at the second calibration data point based on the control error value, it may respond with NAK to the second received power packet (RP/2).

An example of constructing a power calibration curve with two calibration data points has been described, but depending on the embodiment, a power calibration curve may be configured with three or more calibration data points using additional RP/2, and foreign object detection may be performed based on this. In this case, the wireless power transmitter 1010 performs Slotted Q FOD even after receiving the additional RP / 2, whether or not a foreign object exists between the wireless power transmitter 1010 and the wireless power receiver 1020 may be checked.

According to the power calibration method described with reference to FIG. 26, after receiving the first received power packet (RP/1) and the second received power packet (RP/2) from the wireless power receiver 1020, the wireless power transmitter 1010 performs Slotted Q FOD, respectively. Since it is checked whether a foreign object exists between the wireless power transmitter 1010 and the wireless power receiver 1020, during the power calibration process, incorrect power calibration due to the presence of a foreign object can be prevented.

On the other hand, in the foreign object detection method based on the loss of transmission power described above, if an increase in power loss occurs even though a foreign object does not exist during power transmission after power calibration, the wireless power transmission device determines that power loss has occurred due to a foreign object, this results in stopping power transmission or reducing the transmission power to 5W or less.

For example, if movement occurs in the wireless power receiver 1020 during power transmission after power calibration is performed and the alignment between the primary coil and the secondary coil is poor, the received power received by the wireless power receiver is reduced. The wireless power transmitter detects that power loss has increased based on the received power value included in the received power packet (RP/0) received from the wireless power receiver, it is determined that power loss has occurred due to a foreign object.

In addition, a decrease in power loss may occur during power transmission after power calibration is performed. In this case, the wireless power transmitter may determine an abnormal state, stop power transmission, or reduce the level of transmission power or wireless power received by the wireless power receiver to a certain level (eg, 5W) or less.

For example, when a foreign object present in the power calibration process is removed or movement occurs in the wireless power receiver 1020 and the alignment between the primary coil and the secondary coil is good, the received power received by the wireless power receiver increases. The wireless power transmitter detects that the power loss has decreased based on the received power value included in the received power packet (RP/0) received from the wireless power receiver.

As described above, when a change in power loss amount occurs during power transmission after power calibration, it is necessary to determine whether the change in power loss amount is due to a foreign object. However, as described above, the foreign object detection method based on the loss of transmission power judges the increase in power loss as the result of the existence of the foreign object, it is not possible to determine whether the change in power loss amount is due to a foreign object.

Hereinafter, a power transmission method capable of determining whether or not the change in the amount of power loss is due to a foreign object when a change in the amount of power loss occurs during power is described.

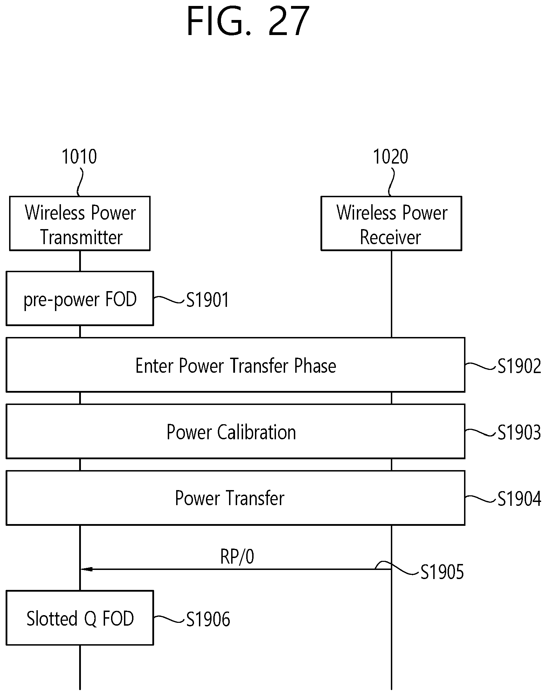

FIG. 27 is a flowchart illustrating a method of determining a foreign object during power transfer according to an exemplary embodiment.

Referring to FIG. 27, the wireless power transmitter 1010 performs foreign object detection (pre-power FOD) before power transfer before entering the power transfer phase (S 1901). Pre-power FOD may be foreign object detection performed in step S1101 described with reference to FIG. 9 and/or foreign object detection performed in step S1301 described with reference to FIG. 12.

The wireless power transmitter 1010 and the wireless power receiver 1020 enter a power transfer phase through a ping phase, a configuration phase, a negotiation phase, and the like (S1902).

At the start time of the power transfer phase, the wireless power transmitter 1010 and the wireless power receiver 1020 perform power calibration (S1903). Since the power calibration process has been described with reference to FIGS. 22 to 25 or 26, further description thereof will be omitted.

After the power calibration process is completed, the wireless power transmitter 1010 transmits wireless power to the wireless power receiver 1020, the wireless power receiver 1020 receives wireless power from the wireless power transmitter 1010 (S1904).

In the power transfer phase, the wireless power receiver 1020 continuously transmits a received power packet (eg, RP/0 having a mode field value of 0) to the wireless power transmitter 1010 (S1905).

The wireless power transmitter 1010 checks the received power value received by the wireless power receiver 1020 through the received power packet, if the difference between the calibrated power value calculated by applying the transmit power value to the power calibration curve and the received power value confirmed through the received power packet is greater than a threshold value, it can be determined that the power loss amount has changed. Variation in the amount of power loss may include an increase or decrease in power loss.

When it is determined that a change in power loss has occurred, the wireless power transmitter 1010 performs Slotted Q FOD (S1906), it is determined whether a foreign object exists between the wireless power transmitter 1010 and the wireless power receiver 1020. Since the specific details of the Slotted Q FOD have been described above with reference to FIGS. 15 to 20, an additional description thereof will be omitted.

According to the embodiment, the wireless power transmitter 1010 performs Slotted Q FOD multiple times, it is possible to determine whether a foreign object exists by using the average of a plurality of measured Q factor values or the average of values excluding the maximum and minimum values among the plurality of measured Q factor values.

On the other hand, depending on the type/material of the foreign object, there are some foreign objects that respond sensitively to the Q factor value, but there are also foreign objects that respond more sensitively to changes in frequency than the Q factor value.

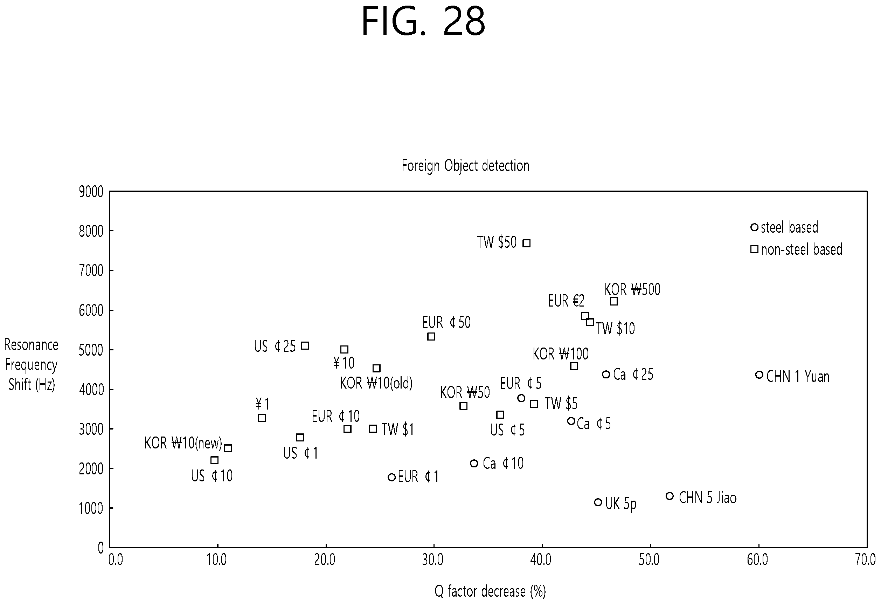

FIG. 28 is a chart showing experimental values of frequency change and Q factor reduction for coins of each country.

Referring to FIG. 28, while a coin made of a steel base is present between the wireless power transmitter and the wireless power receiver as a foreign object, the Q factor decreases remarkably, when a coin made of non-steel base exists between the wireless power transmitter and the wireless power receiver as a foreign object, it can be confirmed that the frequency change appears more prominently than the Q factor decrease.

In order to improve the detection capability of foreign objects that have little effect on the Q factor, the wireless power transmitter 1010 calculates the frequency of the attenuated waveform detected within the slot time while performing Slotted Q FOD, by comparing this with the reference frequency, the amount of change in frequency can be detected. For example, the wireless power transmitter 1010 uses the time interval of the peak values (P1, P2, P3, ..., $P^n$) of the voltage value or current value of the primary coil (Lp) within the slot time, it can compute frequency. The reference frequency is a reference resonance frequency included in the foreign object status packet (FOD) received from the wireless power receiver 1020, or it may be a pre-stored reference frequency value in the manufacturing process of the wireless power transmitter 1010.

Based on the Q factor value and / or frequency change value confirmed as a result of performing Slotted Q FOD, the wireless power transmitter 1010 estimates whether a foreign object exists between the wireless power transmitter 1010 and the wireless power receiver 1020.

If a foreign object is assumed to exist, the wireless power transmitter 1010 stops transmitting wireless power, or the level of the wireless power to be transmitted or the wireless power to be received by the wireless power receiver 1020 may be reduced to a certain level (e.g., 5W) or less.

When it is estimated that the foreign object does not exist, the wireless power transmitter 1010 may transmit a message for inducing power calibration to the wireless power receiver 1020. A message for inducing power calibration may be referred to as a power calibration request packet.

The wireless power transmitter 1010 transmits a power calibration request packet, an ATN response pattern may be transmitted to the wireless power receiver 1020 in response to the received power packet (RP/0) received from the wireless power receiver 1020. The ATN response pattern is an 8-bit response pattern ('11001100' b), when there is a data packet to be transmitted by the wireless power transmitter 1010, etc., it can be used to request communication permission from the wireless power receiver 1020.

To request transmission of data packets from the wireless power transmitter 1010, the wireless power receiver 1020 receiving the ATN may transmit a data stream response packet (DSR/poll) to the wireless power transmitter 1010. DSR/poll is a type of data stream response packet (DSR) transmitted by the wireless power receiver 1020, and has an 8-bit message field, and a value of 0x33 may be set in the corresponding message field.

The wireless power transmitter 1010 receiving the DSR/poll from the wireless power receiver 1020 may transmit a power calibration request packet requesting the start of a power calibration protocol to the wireless power receiver 1020.

The wireless power receiver 1020 receiving the power calibration request packet from the wireless power transmitter 1010 may initiate a power calibration protocol by transmitting a first received power packet (RP/1). Since the power calibration protocol has been described with reference to FIGS. 22 to 25 or 26, further description thereof will be omitted.

The power transmission method according to the embodiment described with reference to FIG. 27 may determine whether the change in power loss amount is due to a foreign object when a change in power loss amount occurs during power supply.

Accordingly, when the change in power loss amount is not due to a foreign object, wireless charging may be maintained by performing power recalibration without stopping wireless charging.

In addition, since the existence of a foreign object is determined based on the Q factor value and frequency change value calculated in the process of performing Slotted Q FOD, regardless of the material/type of the foreign object, the presence of a foreign object can be judged more accurately.

The wireless power transmitter in the embodiment according to the above-described FIGS. 9 to 28 corresponds to the wireless power transmission apparatus or the wireless power transmitter or the power transmission unit disclosed in FIGS. 1 to 8. Accordingly, the operation of the wireless power transmitter in this embodiment is implemented by one or the same or more than two combinations of each component of the wireless power transmitter in FIGS. 1 to 8. For example, reception/transmission of a message or data packet, FOD, etc. according to FIGS. 9 to 28 is included in the operation of the communication/control unit.

The wireless power receiving apparatus in the embodiment according to the above-described FIGS. 9 to 28 corresponds to the wireless power receiving apparatus or the wireless power receiver or the power receiving unit disclosed in FIGS. 1 to 8. Accordingly, the operation of the wireless power receiver in this embodiment is implemented by one or the same or a combination of two or more of the respective components of the wireless power receiver in FIGS. 1 to 8. For example, reception/transmission of a message or data packet according to FIGS. 9 to 28 may be included in the operation of the communication/control unit.

Since all components or steps are not essential for the wireless power transmission method and apparatus, or the reception apparatus and method according to the embodiment of the present document described above, an apparatus and method for transmitting power wirelessly, or an apparatus and method for receiving power may be performed by including some or all of the above-described components or steps. In addition, the above-described wireless power transmission apparatus and method, or the embodiment of the reception apparatus and method may be performed in combination with each other. In addition, each of the above-described components or steps is not necessarily performed in the order described, and it is also possible that the steps described later are performed before the steps described earlier.

The above description is merely illustrative of the technical idea of the present document, those of ordinary skill in the art to which the present document pertains will be able to make various modifications and variations without departing from the essential characteristics of the present document. Accordingly, the embodiments of the present document described above may be implemented separately or in combination with each other.

Accordingly, the embodiments disclosed in the present document are not intended to limit the technical spirit of the present document, but to explain, and the scope of the technical spirit of the present document is not limited by these embodiments. The protection scope of the present document should be construed by the following claims, all technical ideas within the scope equivalent thereto should be construed as being included in the scope of the present document.

**Claims**

1. A method for transmitting wireless power to a wireless power receiver, the method performed by a wireless power transmitter and comprising:

a ping phase for transmitting a digital ping to the wireless power receiver and receiving a response for the digital ping from the wireless power receiver;
a configuration phase for receiving a configuration packet from the wireless power receiver;
a negotiation phase for receiving a foreign object detection status packet including information related to a reference quality factor value from the wireless power receiver, and detecting a foreign object based on the reference quality factor value; and
a power transfer phase for transmitting the wireless power to the wireless power receiver;
wherein, in the power transfer phase,
a received power packet including information related to a received power value is received from the wireless power receiver,
based on the received power value, the transmission of the wireless power is stopped during a slot time, and the foreign object is detected based on a change in voltage or current within the slot time.

2. The method of claim 1, wherein, based on that a decrease in power loss is detected based on the received power value and the foreign object is not detected,
a message for inducing power calibration is transmitted to the wireless power receiver.

3. The method of claim 2, wherein, in a process of performing the power calibration,

a first mode received power packet including information related to a first calibration data point for the power calibration is received from the wireless power receiver,
the transmission of the wireless power is stopped during a slot time, and the foreign object is detected based on a change in voltage or current within the slot time.

4. The method of claim 3, wherein, based on that the foreign object is not detected after receiving the first mode received power packet, an ACK response is transmitted to the wireless power receiver.

5. The method of claim 3, wherein, in a process of performing the power calibration,

a second mode received power packet including information related to a second calibration data point for the power calibration is received from the wireless power receiver,
the transmission of the wireless power is stopped during a slot time, and the foreign object is detected based on a change in voltage or current within the slot time.

6. The method of claim 5, wherein, based on that the foreign object is not detected after receiving the second mode received power packet, an ACK response is transmitted to the wireless power receiver.

7. The method of claim 5, wherein, in the process of performing the power calibration,
a power calibration curve is constructed based on the first calibration data point and the second calibration data point.

8. The method of claim 1, wherein, based on that an increase in power loss is detected based on the received power value and the foreign object is detected,
the transmission of the wireless power is stopped or a level of the wireless power is reduced below a certain level.

9. The method of claim 1, wherein, based on that an increase in power loss is detected based on the received power value and the foreign object is not detected,
a message for inducing power calibration is transmitted to the wireless power receiver.

10. The method of claim 1, wherein a frequency value calculated from a change in voltage or current within the slot time is calculated,
the foreign object is detected based on a difference between the calculated frequency value and a reference frequency value.

11. A wireless power transmitter, which transmits wireless power to a wireless power receiver, comprising:

a power conversion circuit including a primary coil for transmitting the wireless power to the wireless power receiver; and
a communication/control circuit for communicating with the wireless power receiver and controlling the power conversion circuit,

wherein the communication/control circuit performs:

a ping phase for transmitting a digital ping to the wireless power receiver and receiving a response for the digital ping from the wireless power receiver;

a configuration phase for receiving a configuration packet from the wireless power receiver;

a negotiation phase for receiving a foreign object detection status packet including information related to a reference quality factor value from the wireless power receiver, and detecting a foreign object based on the reference quality factor value; and

a power transfer phase for transmitting the wireless power to the wireless power receiver;

wherein, in the power transfer phase,

a received power packet including information related to a received power value is received from the wireless power receiver,

based on the received power value, the transmission of the wireless power is stopped during a slot time, and the foreign object is detected based on a change in voltage or current of the primary coil within the slot time.

12. The wireless power transmitter of claim 11, wherein the communication/control circuit is configured to,

based on that a decrease in power loss is detected based on the received power value and the foreign object is not detected,

transmit a message for inducing power calibration to the wireless power receiver.

13. The wireless power transmitter of claim 12, wherein the communication/control circuit is configured to,

in a process of performing the power calibration,

receive a first mode received power packet including information related to a first calibration data point for the power calibration from the wireless power receiver,

stop the transmission of the wireless power during a slot time, and detect the foreign object based on a change in voltage or current within the slot time.

14. The wireless power transmitter of claim 13, wherein the communication/control circuit is configured to, based on that the foreign object is not detected after receiving the first mode received power packet, transmit an ACK response to the wireless power receiver.

15. The wireless power transmitter of claim 13, wherein the communication/control circuit is configured to,

in a process of performing the power calibration,

receive a second mode received power packet including information related to a second calibration data point for the power calibration from the wireless power receiver,

stop the transmission of the wireless power during a slot time, and detect the foreign object based on a change in voltage or current within the slot time.

16. The wireless power transmitter of claim 15, wherein the communication/control circuit is configured to, based on that the foreign object is not detected after receiving the second mode received power packet, transmit an ACK response to the wireless power receiver.

17. The wireless power transmitter of claim 15, wherein the communication/control circuit is configured to,

in the process of performing the power calibration,

construct a power calibration curve based on the first calibration data point and the second calibration data point.

18. The wireless power transmitter of claim 11, wherein the communication/control circuit is configured to,

based on that an increase in power loss is detected based on the received power value and the foreign object is detected,

stop the transmission of the wireless power or reduce a level of the wireless power below a certain level.

19. The wireless power transmitter of claim 11, wherein the communication/control circuit is configured to,

based on that an increase in power loss is detected based on the received power value and the foreign object is not detected,
transmit a message for inducing power calibration to the wireless power receiver.

20. The wireless power transmitter of claim 11, wherein the communication/control circuit is configured to,

calculate a frequency value calculated from a change in voltage or current of the primary coil within the slot time,
detect the foreign object based on a difference between the calculated frequency value and a reference frequency value.

# FIG. 1

10

100

200

Source ⟶ | wireless power transmitter | ⟶ | wireless power receiver |

# FIG. 2

# FIG. 3a

| Mobile Device |
|---|

<5W          <20W

| IT & Home Appliance |
|---|

<50W          <200W

| Kitchen Appliance | Personal Mobility | xEV Charger |
|---|---|---|

3.3KW/7.7KW/~22KW

<2KW          <22KW

# FIG. 3b

|  | b7 | b6 | b5 | b4 | b3 | b2 | b1 | b0 |
|---|---|---|---|---|---|---|---|---|
| Byte 0 | Application Profile | | | | | | | |
| Byte 1 | Version | | | | | | | |
| Byte 2-N-1 | Profile-specific data | | | | | | | |

# FIG. 4

# FIG. 5

# FIG. 6

# FIG. 7

EP 4 228 123 A1

Block diagram showing:
- 700 WIRELESS POWER TRANSMISSION DEVICE
- 720 COVER
- 710 POWER TRANSMITTER (740)
- 760 COIL ASSEMBLY
- 790 COMMUNICATION UNIT
- 770 IMPEDANCE MATCHING CIRCUIT
- CONTROL UNIT
- 750 USER INTERFACE
- 730 POWER ADAPTER
- 780 INVERTER

# FIG. 8

EP 4 228 123 A1

# FIG. 9

# FIG. 10

# FIG. 11

|  | b7 | b6 | b5 | b4 | b3 | b2 | b1 | b0 |
|---|---|---|---|---|---|---|---|---|
| B0 | '00' | | Reference Power | | | | | |
| B1 | Reserved | | | | | | | |
| B2 | ZERO | AI | Reserved | OB | ZERO | Count | | |
| B3 | Window Size | | | | Window Offset | | | |
| B4 | Neg | Pol | Depth | | Buffer Size | | | Dup |

# FIG. 12

1010

1020

Wireless Power
Transmitter

Wireless Power
Receiver

FOD — S1301

ACK / NAK — S1302

GRQ/id — S1303

ID — S1304

GRQ/cap — S1305

CAP — S1306

SRQ — S1307

ACK / NAK — S1308

# FIG. 13

| | b7 | b6 | b5 | b4 | b3 | b2 | b1 | b0 |
|---|---|---|---|---|---|---|---|---|
| B0 | Reserved | | Negotiable Load Power | | | | | |
| B1 | Reserved | | Potential Load Power | | | | | |
| B2 | Dup | AR | OB | Buffer Size | | | WPID | NRS |

# FIG. 14

# FIG. 15

Full-bridge
Inverter

H1    H2    $C_P$

Input
Voltage    Control    $L_P$

L1    L2

# FIG. 16

# FIG. 17

Start Slotted Q FOD — S1501

S1502

NO ← $I_{coil} = 0$

YES

Cut off power — S1503

Get the data — S1504

Detect peak value — S1505

Regression analysis — S1506

Acquire the Q factor — S1507

Detect foreign object — S1508

End Slotted Q FOD — S1509

# FIG. 18

# FIG. 19

# FIG. 20

$$y=137.79e^{-7236x}$$

# FIG. 21

```
┌─────────────────────────────┐
│     Provide drive power     │───S1601
└─────────────────────────────┘
              │
              ▼
┌─────────────────────────────┐
│      Cut off drive power    │───S1602
└─────────────────────────────┘
              │
              ▼
┌─────────────────────────────┐
│        Get the data         │───S1603
└─────────────────────────────┘
              │
              ▼
┌─────────────────────────────┐
│      Detect peak value      │───S1604
└─────────────────────────────┘
              │
              ▼
┌─────────────────────────────┐
│      Regression analysis    │───S1605
└─────────────────────────────┘
              │
              ▼
┌─────────────────────────────┐
│      Acquire the Q factor   │───S1606
└─────────────────────────────┘
```

# FIG. 22

```
        1010                           1020
┌─────────────────┐          ┌─────────────────┐
│ Wireless Power  │          │ Wireless Power  │
│   Transmitter   │          │    Receiver     │
└─────────────────┘          └─────────────────┘
         │                             │
         │      Control error packet   │
         │◄────────────────────────────│  S1701
         │                             │
         │   First received power packet│
         │◄────────────────────────────│  S1702
         │                             │
         │            ACK              │
         │────────────────────────────►│  S1703
         │                             │
         │      Control error packet   │
         │◄────────────────────────────│  S1704
         │                             │
         │  Second received power packet│
         │◄────────────────────────────│  S1705
         │                             │
         │            ACK              │
         │────────────────────────────►│  S1706
         │                             │
┌─────────────────┐                    │
│  Perform FOD    │  S1107             │
└─────────────────┘                    │
         │                             │
```

# FIG. 23

# FIG. 24

|  | $b_7$ | $b_6$ | $b_5$ | $b_4$ | $b_3$ | $b_2$ | $b_1$ | $b_0$ |
|---|---|---|---|---|---|---|---|---|
| $B_0$ | Reserved | | | | | Mode | | |
| $B_1$ | (msb) | | | | | | | |
| $B_2$ | Estimated Received Power value | | | | | | | (lsb) |

# FIG. 25

EP 4 228 123 A1

| | b7 | b6 | b5 | b4 | b3 | b2 | b1 | b0 |
|---|---|---|---|---|---|---|---|---|
| $B_0$ | Setting Time | | Slot Length | | | Mode | | |
| $B_1$ | (mbs) Estimated Received Power value | | | | | | | |
| $B_2$ | | | | | | | | (lsb) |

# FIG. 26

1010

1020

```
┌──────────────────┐              ┌──────────────────┐
│  Wireless Power  │              │  Wireless Power  │
│   Transmitter    │              │     Receiver     │
└──────────────────┘              └──────────────────┘
```

Control error packet ──────────────── S1701

First received power packet ──────────── S1702

┌──────────────────┐
│   Slotted Q FOD  │── S1801
└──────────────────┘

ACK ──────────────── S1703

Control error packet ──────────────── S1704

Second received power packet ──────────── S1705

┌──────────────────┐
│   Slotted Q FOD  │── S1802
└──────────────────┘

ACK ──────────────── S1706

┌──────────────────┐
│   Perform FOD    │── S1107
└──────────────────┘

# FIG. 27

1010

1020

| Wireless Power Transmitter | | Wireless Power Receiver |

pre-power FOD — S1901

Enter Power Transfer Phase — S1902

Power Calibration — S1903

Power Transfer — S1904

RP/0 — S1905

Slotted Q FOD — S1906

FIG. 28

## INTERNATIONAL SEARCH REPORT

| International application No. |
| --- |
| **PCT/KR2021/013817** |

### A. CLASSIFICATION OF SUBJECT MATTER

**H02J 50/60**(2016.01)i; **H02J 50/12**(2016.01)i; **H01F 38/14**(2006.01)i

According to International Patent Classification (IPC) or to both national classification and IPC

### B. FIELDS SEARCHED

Minimum documentation searched (classification system followed by classification symbols)

H02J 50/60(2016.01); H02J 7/00(2006.01); H02J 7/02(2006.01); H04W 52/02(2009.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 무선 전력(wireless power), 이물질(foreign object), 디지털 핑(digital ping), 패킷 (packet), 품질(quality), 협상(negotiation), 슬롯(slot), 보정(compensation)

### C. DOCUMENTS CONSIDERED TO BE RELEVANT

| Category* | Citation of document, with indication, where appropriate, of the relevant passages | Relevant to claim No. |
| --- | --- | --- |
| Y | KR 10-2018-0025602 A (LG INNOTEK CO., LTD.) 09 March 2018 (2018-03-09)<br>See paragraphs [0092]-[0262], claims 1-27, and figures 5-16. | 1-20 |
| Y | KR 10-2017-0044495 A (SAMSUNG ELECTRO-MECHANICS CO., LTD.) 25 April 2017 (2017-04-25)<br>See paragraphs [0071]-[0090], claims 1-15, and figures 6-7. | 1-20 |
| A | US 2017-0273025 A1 (APPLE INC.) 21 September 2017 (2017-09-21)<br>See paragraphs [0076]-[0107], and figures 6A-7. | 1-20 |
| A | WO 2015-194969 A1 (POWERBYPROXI LIMITED) 23 December 2015 (2015-12-23)<br>See pages 4-8, and figure 1. | 1-20 |
| A | KR 10-2016-0012889 A (LG ELECTRONICS INC.) 03 February 2016 (2016-02-03)<br>See paragraphs [0313]-[0404], claims 1-20, and figures 22-32. | 1-20 |

☐ Further documents are listed in the continuation of Box C.　　☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **11 January 2022** | **11 January 2022** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**
Information on patent family members

International application No.

**PCT/KR2021/013817**

| Patent document cited in search report | | | Publication date (day/month/year) | Patent family member(s) | | | Publication date (day/month/year) |
|---|---|---|---|---|---|---|---|
| KR | 10-2018-0025602 | A | 09 March 2018 | None | | | |
| KR | 10-2017-0044495 | A | 25 April 2017 | CN | 106602739 | A | 26 April 2017 |
| | | | | US | 2017-0110913 | A1 | 20 April 2017 |
| US | 2017-0273025 | A1 | 21 September 2017 | CN | 109076456 | A | 21 December 2018 |
| | | | | CN | 109076456 | B | 14 May 2021 |
| | | | | EP | 3406101 | A1 | 28 November 2018 |
| | | | | EP | 3406101 | B1 | 02 June 2021 |
| | | | | JP | 2019-507555 | A | 14 March 2019 |
| | | | | JP | 6570762 | B2 | 04 September 2019 |
| | | | | KR | 10-2018-0108728 | A | 04 October 2018 |
| | | | | KR | 10-2020-0013077 | A | 05 February 2020 |
| | | | | KR | 10-2264190 | B1 | 10 June 2021 |
| | | | | US | 10123277 | B2 | 06 November 2018 |
| | | | | US | 10660040 | B2 | 19 May 2020 |
| | | | | US | 2019-0045450 | A1 | 07 February 2019 |
| | | | | US | 2020-0245251 | A1 | 30 July 2020 |
| | | | | WO | 2017-164966 | A1 | 28 September 2017 |
| WO | 2015-194969 | A1 | 23 December 2015 | CN | 107078518 | A | 18 August 2017 |
| | | | | CN | 107078518 | B | 28 February 2020 |
| | | | | EP | 3158621 | A1 | 26 April 2017 |
| | | | | JP | 2017-521040 | A | 27 July 2017 |
| | | | | JP | 6633066 | B2 | 22 January 2020 |
| | | | | KR | 10-2017-0018454 | A | 17 February 2017 |
| | | | | KR | 10-2222222 | B1 | 03 March 2021 |
| | | | | US | 10879743 | B2 | 29 December 2020 |
| | | | | US | 2017-0163100 | A1 | 08 June 2017 |
| | | | | US | 2019-0229561 | A1 | 25 July 2019 |
| KR | 10-2016-0012889 | A | 03 February 2016 | CN | 106537727 | A | 22 March 2017 |
| | | | | CN | 106537727 | B | 10 May 2019 |
| | | | | CN | 110224448 | A | 10 September 2019 |
| | | | | EP | 3172813 | A1 | 31 May 2017 |
| | | | | EP | 3172813 | B1 | 08 May 2019 |
| | | | | EP | 3499682 | A1 | 19 June 2019 |
| | | | | EP | 3499682 | B1 | 26 August 2020 |
| | | | | ES | 2729160 | T3 | 30 October 2019 |
| | | | | HU | E043428 | T2 | 28 August 2019 |
| | | | | JP | 2017-522851 | A | 10 August 2017 |
| | | | | JP | 2018-148796 | A | 20 September 2018 |
| | | | | JP | 6366814 | B2 | 01 August 2018 |
| | | | | JP | 6619848 | B2 | 11 December 2019 |
| | | | | PL | 3172813 | T3 | 30 September 2019 |
| | | | | TR | 201908279 | T4 | 21 June 2019 |
| | | | | US | 10079513 | B2 | 18 September 2018 |
| | | | | US | 10601253 | B2 | 24 March 2020 |
| | | | | US | 2017-0207663 | A1 | 20 July 2017 |
| | | | | US | 2019-0044388 | A1 | 07 February 2019 |
| | | | | WO | 2016-013778 | A1 | 28 January 2016 |

Form PCT/ISA/210 (patent family annex) (July 2019)